# EUROPEAN PATENT APPLICATION

(11) **EP 4 737 953 A1**
(43) Date of publication of application: **06.05.2026**
(21) Application number: 25179297.4
(22) Date of filing: 28.05.2025
(51) Int. Cl.: G02B 1/14, G02B 1/18, H10K 59/12, H10K 59/38, H10K 59/80, H10K 77/10, H10K 102/00

(54) **DISPLAY DEVICE INCLUDING A COVER WINDOW WITH A FUNCTIONAL LAYER AND ELECTRONIC DEVICE INCLUDING THE SAME**

(30) Priority: 05.11.2024 KR 20240154832
(71) Applicant: Samsung Display Co., Ltd., Yongin-si, Gyeonggi-do 17113 (KR)
(72) Inventor: Lee, Heeyoung, 17113 Yongin-si, Gyeonggi-do (KR); An, Sungguk, 17113 Yongin-si, Gyeonggi-do (KR); Han, Soyeon, 17113 Yongin-si, Gyeonggi-do (KR); Ko, Jisun, 17113 Yongin-si, Gyeonggi-do (KR); Kim, Jungwook, 17113 Yongin-si, Gyeonggi-do (KR); Eom, Jimi, 17113 Yongin-si, Gyeonggi-do (KR); Yun, Jooho, 17113 Yongin-si, Gyeonggi-do (KR); Lee, Seungri, 17113 Yongin-si, Gyeonggi-do (KR)
(74) Representative: Gulde & Partner

(57) **Abstract**

A display device includes at least one folding area. The display device includes a display panel and a cover window disposed on the display panel The cover window includes a base layer and a functional layer disposed on the base layer and has an anti-fingerprint material disposed thereon. At least a portion of the anti-fingerprint material floats on an outermost surface of the functional layer.

## Description

### TECHNICAL FIELD

The present disclosure relates to a display device and, more specifically, to a display device including a cover window having a functional layer and an electronic device including the display device.

### DISCUSSION OF THE RELATED ART

Electronic devices often incorporate display panels so as to produce an image for a user. Traditionally, display panels have been flat and rigid. However, modern display panels may be capable of being bent into a desired curvature or may be designed for repeated folding to a noticeable degree without cracking or otherwise sustaining damage. Such display panel are often referred to as foldable display panels.

While traditional display panels may utilize highly transparent windows, such as those made of a thick glass, so as to create a high-quality visual appearance and to provide superior scratch resistance, foldable display panels might not be able to make use of thick glass windows and may therefore suffer from reduced clarity and/or scratch resistance.

### SUMMARY

Various aspects relate to a display device including at least one folding area, a display panel configured to display an image, and a cover window disposed on the display panel. The cover window includes a base layer and a functional layer disposed on the base layer. The functional layer may have a thickness in a range from about 2 micrometers to about 21 micrometers, inclusive. The functional layer may include a hard coating layer disposed on the base layer and including a hard coating material. The functional layer may include a refractive layer disposed on the hard coating layer. The refractive layer may include an anti-fingerprint material. At least a portion of the anti-fingerprint material may be disposed at an outermost surface of the refractive layer.

According to various aspects, the refractive layer may include at least one low refractive layer including a low refractive material. The at least one low refractive layer may include the low refractive material and may have the anti-fingerprint material disposed therein. At least a portion of the anti-fingerprint material may be disposed at an outermost surface of the at least one low refractive layer.

According to various aspects, the refractive layer may include at least one high refractive layer including a high refractive material, and at least one low refractive layer disposed on the at least one high refractive layer and including a low refractive material. The at least one low refractive layer may include the low refractive material and may have the anti-fingerprint material disposed therein. At least a portion of the anti-fingerprint material may be disposed at on an outermost surface of the at least one low refractive layer.

According to various aspects, the anti-fingerprint material may include at least one material of a water-repellent material, an oil-repellent material, a fluorine-based material, and/or a silicon-based material.

According to various aspects, the anti-fingerprint material may include at least one fluorine-based material of polytetrafluoroethylene (PTFE), fluorinated ethylene propylene (FEP), perfluoropolyether (PFPE), and fluorinated silane, or at least one silicon-based material of silica nanoparticles (SiO₂), hexamethyldisiloxane (HMDSO), tetraethyl orthosilicate (TEOS), polydimethylsiloxane (PDMS), and phenylmethylsilicone.

According to various aspects, a density of the anti-fingerprint material may be higher in a portion of the refractive layer farther from the base layer than in a portion of the refractive layer closer to the base layer.

According to various aspects, the refractive layer may have a surface contact angle from about 100 degrees to about 120 degrees, inclusive.

According to various aspects, the display device may include an adhesive layer disposed between the display panel and the cover window. The adhesive layer may include a pressure sensitive adhesive (PSA) that is a semi-fluidic material.

According to various aspects, at least one of the base layer, the hard coating layer, and/or the adhesive layer may further include an ultraviolet blocking material. The ultraviolet blocking material may transmit 10 % or less ultraviolet light that has a wavelength of 380 nm or less.

According to various aspects, the ultraviolet blocking material may be (e.g., uniformly) distributed within at least one of the base layer, the hard coating layer, and/or the adhesive layer.

According to various aspects, the hard coating material may include at least one material of siloxane resin, epoxy resin, and/or acryl-based resin, and a thickness of the hard coating layer may be in a range from about 1 micrometer to about 20 micrometers, inclusive.

According to various aspects, the low refractive material may include at least one material of an amino-based low refractive material, a silane-based low refractive material, and/or an acrylate-based low refractive material, and a thickness of the at least one low refractive layer may be in a range from about 10 nanometers to about 250 nanometers, inclusive.

According to various aspects, the high refractive material may include at least one high refractive inorganic material or include at least one high refractive organic material and a thickness of the at least one high refractive layer may be in a range from about 10 nanometers to about 250 nanometers. The high refractive material may include at least one high refractive inorganic material of titanium dioxide, zirconium oxide, silicon carbide, zinc sulfide, and/or titanium carbide, or include at least one high refractive organic material from among polyimide and/or polythiophene, and a thickness of the at least one high refractive layer may be in a range from about 10 nanometers to about 250 nanometers, inclusive.

According to various aspects, the display panel may include a substrate, an organic light-emitting diode disposed on the substrate, and an encapsulation layer sealing the organic light-emitting diode. The display device may further include, between the display panel and the cover window, a touch layer disposed on the encapsulation layer, and a color filter layer disposed on the touch layer.

Various aspects relate to a display device including at least one folding area, a display panel configured to display an image, and a cover window disposed on the display panel. The cover window includes a base layer and a functional layer. The functional layer may include a hard coating layer disposed on the base layer, the hard coating layer includes a hard coating material. In some aspects, a primer layer may be disposed on the hard coating layer, the primer layer includes a primer material. In some aspects, an anti-fingerprint layer may be disposed on the primer layer, the anti-fingerprint layer includes an anti-fingerprint material. A thickness of the primer layer may be in a range from about 5 nanometers to about 30 nanometers, inclusive. The primer material may include at least one material of a silane-based material, an acrylate-based material, and/or an epoxy-based material.

According to various aspects, the display device may include, between the hard coating layer and the primer layer, a low refractive layer including a low refractive material and having a thickness in a range from about 10 nanometers to about 250 nanometers, inclusive.

According to various aspects, the display device may include, between the hard coating layer and the low refractive layer, a high refractive layer including a high refractive material having a thickness in a range from about 10 nanometers to about 250 nanometers, inclusive.

According to various aspects, a thickness of the anti-fingerprint layer may be in a range from about 5 nanometers to about 30 nanometers, inclusive. The anti-fingerprint material may include at least one material of a water-repellent material, an oil-repellent material, a fluorine-based material, and/or a silicon-based material.

Various aspects relate to an electronic device including a controller configured to generate a scan input signal. A power module may be configured to generate a scan input voltage. A display panel may include a substrate that is divided into a display area in which a pixel circuit is arranged and a peripheral area surrounding the display area. A scan driver may be arranged in the peripheral area. The scan driver may be configured to receive the scan input signal and the scan input voltage, and output a scan signal to the pixel circuit. In some aspects, an encapsulation layer seals at least the display area. A touch layer may be disposed on the encapsulation layer. A color filter layer may be disposed on the touch layer. A cover window may be disposed on the color filter layer. In various aspects, the cover window includes a base layer and a functional layer disposed on the base layer. The functional layer may have a thickness in a range from about 2 micrometers to about 21 micrometers, inclusive. The functional layer may include an anti-fingerprint material. At least a portion of the anti-fingerprint material may be disposed at an outermost surface of the functional layer. The anti-fingerprint material may include at least one material of a water-repellent material, an oil-repellent material, a fluorine-based material, and/or a silicon-based material.

The functional layer may include a hard coating layer disposed on the base layer, the hard coating layer including a hard coating material, and the hard coating layer having a thickness in a range from about 1 micrometer to about 20 micrometers, inclusive. The hard coating layer may include the anti-fingerprint material and at least a portion of the anti-fingerprint material may be disposed at an outermost surface of the hard coating layer.

According to various aspects, the functional layer may include a hard coating layer disposed on the base layer. The hard coating layer may include a hard coating material and may have a thickness in a range from about 1 micrometer to about 20 micrometers, inclusive. At least one low refractive layer may be disposed on the hard coating layer. The refractive layer may have a thickness that is less than that of the hard coating layer, and the refractive layer may include a low refractive material. The at least one low refractive layer may have the anti-fingerprint material disposed therein. At least a portion of the anti-fingerprint material may be disposed at an outermost surface of the at least one low refractive layer.

According to various aspects, the functional layer may include a hard coating layer disposed on the base layer, the hard coating layer including a hard coating material and having a thickness that is in a range from about 1 micrometer to about 20 micrometers, inclusive. At least one high refractive layer may be disposed on the hard coating layer and may have a thickness that is less than that of the hard coating layer. The high refractive layer may include a high refractive material. At least one low refractive layer may be disposed on the at least one high refractive layer and may have a same thickness as the at least one high refractive layer and may include a low refractive material. The at least one low refractive layer may have the anti-fingerprint material disposed therein and at least a portion of the anti-fingerprint material may be disposed at an outermost surface of the at least one low refractive layer.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a perspective view of a display device according to an embodiment;
FIG. 2 is a perspective view showing a folding state of the display device illustrated in FIG. 1;
FIG. 3 is a perspective view of a display device according to an embodiment;
FIG. 4 is a perspective view showing a folding state of the display device illustrated in FIG. 3;
FIG. 5 is a cross-sectional view of the display device of FIG. 1 taken along line I-I';
FIG. 6 is an enlarged view of a region II of FIG. 5;
FIGS. 7A and 7B are cross-sectional views illustrating a cover window according to an embodiment, which is an enlarged view of a region III of FIG. 5;
FIGS. 8A and 8B are cross-sectional views illustrating a cover window according to an embodiment;
FIG. 9 is a cross-sectional view illustrating a cover window according to an embodiment;
FIG. 10 is a graph illustrating experiment results obtained by comparing wear resistance of a display device according to an embodiment with wear resistance of comparative examples;
FIGS. 11A and 11B are cross-sectional views illustrating a cover window according to an embodiment, which is an enlarged view of the region III of FIG. 5;
FIGS. 12A and 12B are cross-sectional views illustrating a cover window according to an embodiment;
FIG. 13 is a cross-sectional view illustrating a cover window according to an embodiment; and
FIG. 14 is a block diagram of an electronic device according to an embodiment.

### DETAILED DESCRIPTION

The disclosure may have various modifications and various embodiments, and specific embodiments are illustrated in the drawings and are described in detail in the detailed description. Effects and features of the disclosure and methods of achieving the same will become apparent with reference to embodiments described in detail with reference to the drawings. However, the disclosure is not necessarily limited to the embodiments described below, and may be implemented in various forms.

In the following embodiments, the terms "first" and "second" are not necessarily used in a limited sense and may be used to distinguish one component from another component.

In the following embodiments, an expression used in the singular encompasses the expression of the plural, unless it has a clearly different meaning in the context.

In the following embodiments, it will be further understood that the terms "comprise," "include," "including," and/or "comprising" used herein specify the presence of stated features or components, but do not necessarily preclude the presence or addition of one or more other features or components.

It will be understood that when a unit, region, or element is referred to as being "formed on" another unit, area, or element, it can be directly or indirectly formed on the other unit, region, or element. That is, for example, intervening units, regions, or elements may be present.

In the embodiments below, terms such as connect or combine do not necessarily imply a direct and/or fixed connection or combination of two members, unless the context clearly indicates otherwise, and do not exclude the presence of another member between the two members.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like.

According to embodiments, an x-axis, a y-axis, and a z-axis are not necessarily limited to three axes on an orthogonal coordinate system, but may be interpreted in a broad sense including the three axes. For example, the x-axis, the y-axis, and the z-axis may be perpendicular to one another, or may represent different directions that are not perpendicular to one another.

Hereinafter, embodiments will be described in detail with reference to the accompanying drawings, and in the following description with reference to the drawings, like reference numerals may refer to like or corresponding components and to the extent that an element is not described in detail with respect to this figure, it may be understood that the element is at least similar to a corresponding element that has been described elsewhere within the present disclosure.

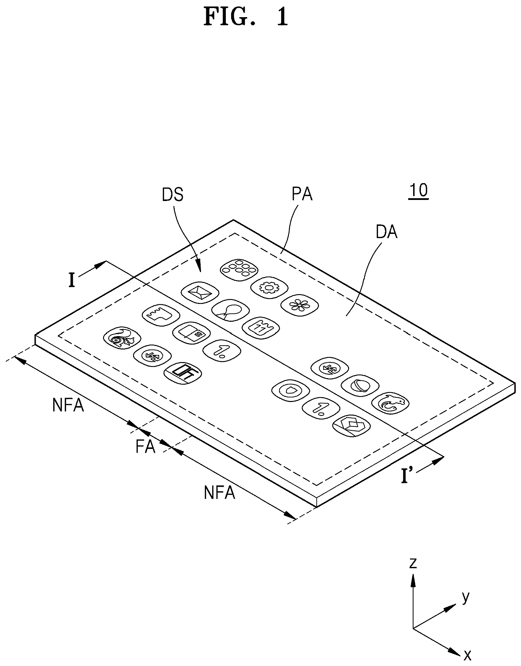

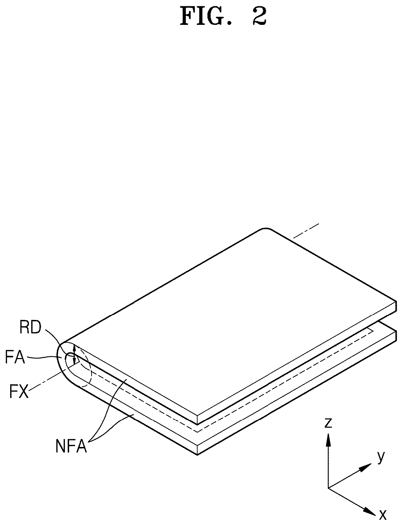

FIG. 1 is a perspective view of a display device 10 according to an embodiment. FIG. 2 is a view showing a folding state of the display device 10 illustrated in FIG. 1.

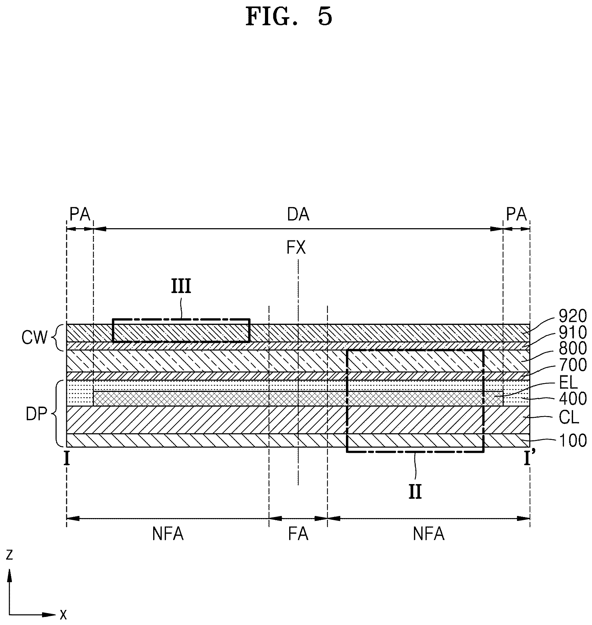

Referring to FIG. 1, the display device 10 may have a substantially rectangular shape having a pair of long sides extending in an x-axis direction and a pair of short sides extending in a y-axis direction. However, an embodiment is not necessarily limited to what is illustrated, and the display device 10 may have any one of various shapes, such as a polygon and a circle, on a plane parallel to a substrate 100 of FIG. 5. The display device 10 may include a curved display device, a bended display device, a foldable display device, a rollable display device, or a stretchable display device.

The display device 10 includes a display surface DS on which a display area DA, where an image may be displayed, is arranged. The display surface DS may be on an xy plane defined by an intersection of an x-axis and a y-axis. A normal direction of the display area DA, i.e., a thickness direction of the display device 10, may be referred to as a z-axis. A front surface (or a top surface) and a rear surface (or a bottom surface) of each member may be distinguished by the z-axis. However, directions indicated by the x-axis, y-axis, and z-axis are relative and may be changed to other directions.

The display surface DS may include the display area DA and a peripheral area PA. The display area DA is a portion in which an image may be displayed, and a plurality of pixels may be arranged in the display area DA. The peripheral area PA may be arranged outside of the display area DA. Various connecting wires and driving circuits may be located in the peripheral area PA.

The display device 10 may include a folding area FA that is folded and a non-folding area NFA that is not folded. As illustrated, the display device 10 may include one folding area FA and a plurality of non-folding areas NFA. In this case, the folding area FA is arranged between the non-folding areas NFA, and the folding area FA and the non-folding area NFA may be arranged adjacent to each other in the x-axis direction. The folding area FA may be a portion that is transformable into a folded shape based on a folding axis FX extending in one direction, i.e., the y-axis direction. A radius of curvature of the folding area FA may be within a range from about 0 mm to about 5 mm.

FIGS. 1 and 2 illustrate one folding area FA and two non-folding areas NFA. However, the numbers of folding areas FA and non-folding areas NFA according to an embodiment are not necessarily limited thereto. For example, the display device 10 may include more than two non-folding areas NFA and a plurality of folding areas FA arranged between adjacent non-folding areas NFA.

As illustrated, the adjacent non-folding areas NFA in the display device 10 may be arranged symmetrically with respect to the folding area FA. However, an embodiment is not necessarily limited thereto, and the folding area FA may be arranged between the adjacent non-folding areas NFA, and the facing non-folding areas NFA may be asymmetrical and have different areas.

Referring to FIG. 2, the display device 10 may be folded when the folding area FA is bent and folded based on the folding axis FX along the y-axis. In FIG. 2, the folding axis FX may be defined as a short axis parallel to the short side of the display device 10. When the display device 10 is folded, the non-folding areas NFA face each other. Accordingly, the display surface DS may be in-folded so as not to have the display surface exposed to the outside. However, an embodiment is not necessarily limited thereto, and the display surface DS may be out-folded so as to remain exposed and visible even when folded.

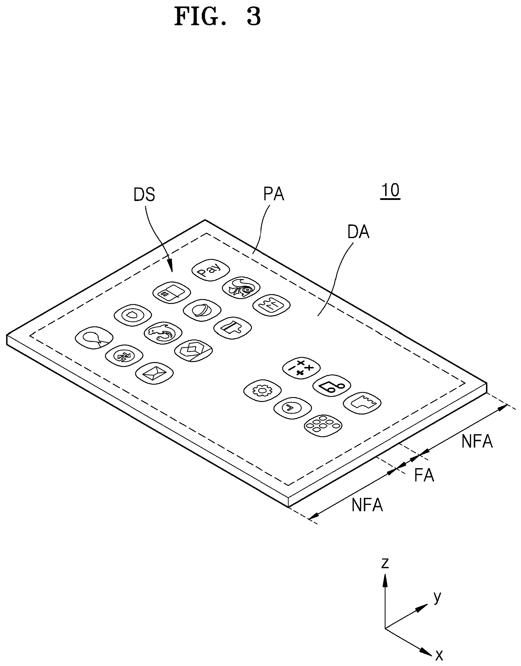

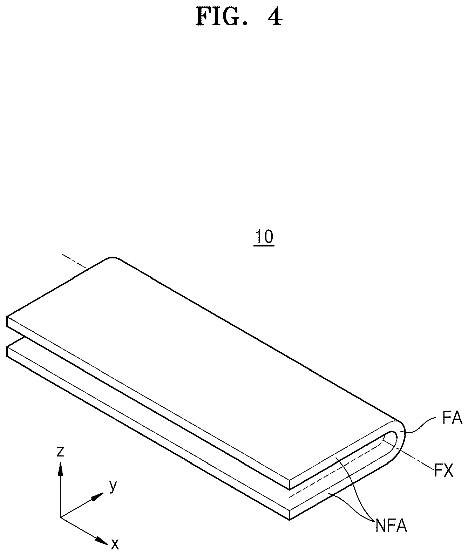

FIG. 3 is a perspective view of the display device 10 according to an embodiment. FIG. 4 is a view showing the folding state of the display device 10 illustrated in FIG. 3.

The display device 10 shown in FIGS. 3 and 4 may have a same configuration as the display device 10 shown in FIGS. 1 and 2, except for a folding operation. In the description about the display device 10 shown in FIGS. 3 and 4 below, the folding operation will be mainly described and to the extent that an element is not described in detail with respect to this figure, it may be understood that the element is at least similar to a corresponding element that has been described elsewhere within the present disclosure.

Referring to FIG. 3, the display device 10 may include the folding area FA that is folded and the non-folding area NFA that is not folded. The folding area FA is arranged between the non-folding areas NFA, and the folding area FA and the non-folding area NFA may be arranged adjacent to each other in the y-axis direction.

Referring to FIG. 4, the display device 10 may be folded when the folding area FA is bent and folded based on the folding axis FX that runs along the x-axis. In FIG. 4, the folding axis FX may be defined as a long axis parallel to the long side of the display device 10. When the display device 10 is folded, the non-folding areas NFA face each other. Accordingly, the display surface DS may be in-folded so as not to be exposed to the outside. However, an embodiment is not necessarily limited thereto, and the display surface DS may be out-folded so as to be exposed to the outside and remain visible, even when folded.

Hereinafter, the display device 10 shown in FIGS. 1 and 2 and/or FIGS. 3 and 4 will be mainly described, but an embodiment is not necessarily limited thereto.

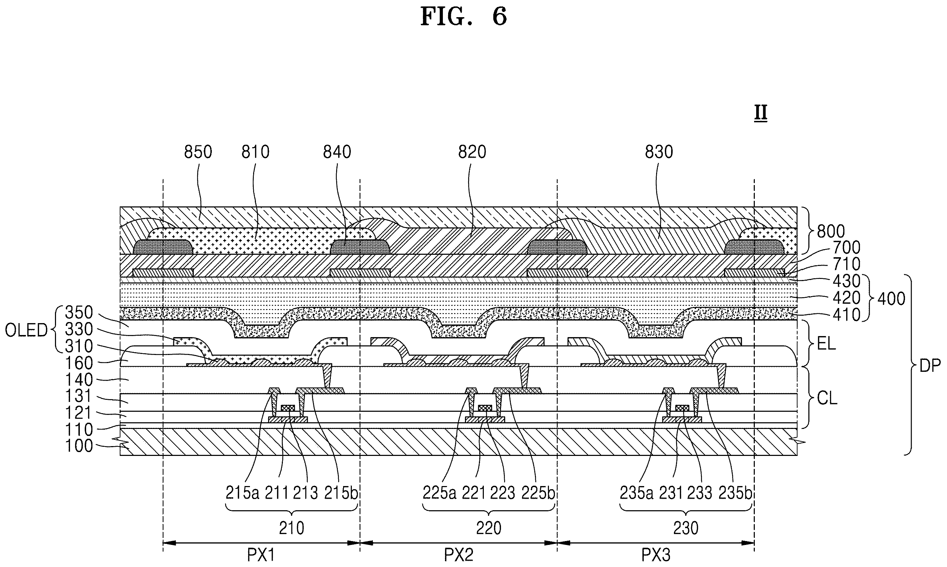

FIG. 5 is a cross-sectional view of the display device 10 of FIG. 1 taken along line I-I'. FIG. 6 is an enlarged view of a region II of FIG. 5.

Referring to FIGS. 5 and 6, the display device 10 may include a display panel DP, a touch layer 700 disposed on the display panel DP, a color filter layer 800 disposed on the touch layer 700, and a cover window CW disposed on the color filter layer 800.

An entire thickness of the display device 10 may be within a range of 0 micrometer to 1500 micrometers.

A display panel DP may include the substrate 100, a circuit layer CL disposed on the substrate 100, a display element layer EL disposed on the circuit layer CL, and an encapsulation layer 400 sealing the display element layer EL.

The substrate 100 may provide a base surface for supporting and protecting a display lower portion. The substrate 100 includes a light and flexible material and a thickness so that the display device 10 may be folded.

The substrate 100 may include glass, a metal, or a polymer resin. The substrate 100 may include, for example, a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. Various modifications are also possible, for example, the substrate 100 may have a multilayered structure including two layers including such a polymer resin, and an inorganic layer arranged between the layers and including an inorganic material such as silicon oxide, silicon nitride, or silicon oxynitride.

A plurality of pixels, for example, a first pixel PX1, a second pixel PX2, and a third pixel PX3, are arranged in the display area DA of the substrate 100. Each pixel may include an organic light-emitting diode. Each pixel may be configured to emit light. Such a pixel may be connected to a pixel circuit including a thin-film transistor (TFT), a storage capacitor, and the like. The pixel circuit may be connected to various connecting wires, such as a scan line configured to transmit a scan signal, a data line crossing the scan line and configured to transmit a data signal, and a driving voltage line configured to supply a driving voltage.

The pixel may emit light of luminance corresponding to an electrical signal from the pixel circuit that is electrically connected to the pixel. The display area DA may display a certain image through light emitted from the pixel. For reference, the pixel may be defined as an area that emits light of any one color from among red, green, and blue.

The peripheral area PA in the substrate 100 may be arranged outside of the display area DA. The peripheral area PA is an area in which the pixel is not arranged, and thus may be an area in which an image is not displayed. A power supply wire configured to drive the pixel may be arranged in the peripheral area PA. A printed circuit board including the driving circuit or a terminal unit to which a driver integrated circuit (IC) is connected may be arranged in the peripheral area PA.

Hereinafter, an organic light-emitting display device will be described as an example of the display device 10 according to an embodiment. However, the display device 10 of the disclosure is not necessarily limited thereto. According to an embodiment, the display device 10 of the disclosure may be an inorganic light-emitting display or an inorganic EL display, or may be a quantum dot light-emitting display. For example, an emission layer of a display element included in the display device 10 may include an organic material or an inorganic material. Also, the display device 10 may include an emission layer and a quantum dot layer disposed on a path of light emitted from the emission layer.

The circuit layer CL is disposed on the substrate 100. Each of the first pixel PX1, the second pixel PX2, and the third pixel PX3 may include a separate pixel circuit. The pixel circuit may include at least two TFTs and one or more storage capacitors. In FIG. 6, only one TFT included in each pixel is illustrated, but this is only an example and various other numbers of TFTs may be included within each pixel.

A first TFT 210 may be arranged in a first pixel area corresponding to the first pixel PX1, a second TFT 220 may be arranged in a second pixel area corresponding to the second pixel PX2, and a third TFT 230 may be arranged in a third pixel area corresponding to the third pixel PX3.

The first TFT 210 may include a first semiconductor layer 211, a first gate electrode 213, a first source electrode 215a, and a first drain electrode 215b, wherein the first semiconductor layer 211 includes amorphous silicon, polycrystalline silicon, an organic semiconductor material, or an oxide semiconductor material. The first gate electrode 213 may include various conductive materials and have various layered structures, for example, may include a molybdenum (Mo) layer and an aluminum (Al) layer. In this case, the first gate electrode 213 may have a layered structure of Mo/Al/Mo. Alternatively, the first gate electrode 213 may include a titanium nitride (TiNx) layer, an Al layer, and/or a titanium (Ti) layer. The first source electrode 215a and the first drain electrode 215b may also include various conductive materials and have various layered structures, for example, may include a Ti layer, an Al layer, and/or a copper (Cu) layer. In this case, the first source electrode 215a and the first drain electrode 215b may have a layered structure of Ti/Al/Ti.

A gate insulating layer 121 including an inorganic material, such as silicon oxide, silicon nitride, and/or silicon oxynitride, may be provided between the first semiconductor layer 211 and the first gate electrode 213, so as to secure insulation between the first semiconductor layer 211 and the first gate electrode 213. In addition, an interlayer insulating layer 131 including an inorganic material, such as silicon oxide, silicon nitride, and/or silicon oxynitride, may be disposed on the first gate electrode 213, and the first source electrode 215a and the first drain electrode 215b may be disposed on the interlayer insulating layer 131. An insulating layer including an inorganic material as such may be formed through chemical vapor deposition (CVD) or atomic layer deposition (ALD). This is also applied to embodiments described below and modifications thereof.

A barrier layer 110 including an inorganic material such as silicon oxide, silicon nitride, and/or silicon oxynitride may be provided between the first TFT 210 having such a structure and the substrate 100. The barrier layer 110 may enhance flatness of a top surface of the substrate 100 or may prevent or reduce impurities from penetrating from the substrate 100 to the first semiconductor layer 211 of the first TFT 210.

The second TFT 220 arranged in the second pixel area of the second pixel PX2 may include a second semiconductor layer 221, a second gate electrode 223, a second source electrode 225a, and a second drain electrode 225b. The third TFT 230 located in the third pixel area of the third pixel PX3 may include a third semiconductor layer 231, a third gate electrode 233, a third source electrode 235a, and a third drain electrode 235b. A structure of the second TFT 220 and a structure of the third TFT 230 are identical or similar to a structure of the first TFT 210 arranged in the first pixel PX1, and thus, to the extent that an element is not described in detail with respect to this figure, it may be understood that the element is at least similar to a corresponding element that has been described elsewhere within the present disclosure.

A planarization layer 140 may be disposed on the first TFT 210. For example, as shown in FIG. 6, when an organic light-emitting diode OLED is disposed on the first TFT 210, the planarization layer 140 covering the first TFT 210 may have an approximately flat top surface, allowing the organic light-emitting diode OLED to be disposed on a flat surface. The planarization layer 140 may include an organic material, for example, acryl, benzocyclobutene (BCB), or hexamethyldisiloxane (HMDSO). In FIG. 6, the planarization layer 140 is illustrated as a single layer, but various modifications are possible, such as the planarization layer 140 being a multilayered structure.

The organic light-emitting diode OLED may be disposed on the planarization layer 140. The organic light-emitting diode OLED may include a pixel electrode 310, an intermediate layer 330 including an emission layer, and an opposing electrode 350.

The pixel electrode 310 may be a (semi-)transmissive electrode or a reflective electrode. For example, the pixel electrode 310 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof, and a transparent or semi-transparent electrode layer disposed on the reflective layer. The transparent or semi-transparent electrode layer may include at least one of indium tin oxide (ITO), indium zinc oxide (IZO), zinc oxide (ZnO), indium oxide (In₂O₃), indium gallium oxide (IGO), and aluminum zinc oxide (AZO). For example, the pixel electrode 310 may have a three-layer structure of ITO/Ag/ITO.

As shown in FIG. 6, the pixel electrode 310 may include a protrusion protruding in a direction of the opposing electrode 350. The protrusion of the pixel electrode 310 improves light emission efficiency. Some of the emitted light may be reflected at various angles through the protrusion, allowing more light to be extracted to the outside. In addition, the protrusion promote light dispersion, allowing the organic light-emitting diode OLED to emit light uniformly across an entire surface.

A pixel-defining layer 160 may be disposed on the planarization layer 140. The pixel-defining layer 160 may increase a distance between an edge of the pixel electrode 310 and the opposing electrode 350 disposed on the pixel electrode 310, thereby preventing occurrence of electrical arcing at the edge of the pixel electrode 310. The pixel-defining layer 160 may include at least one organic insulating material of polyimide, polyamide, acryl resin, benzocyclobutene, and phenol resin, and may be formed through spin coating or the like.

At least a portion of the intermediate layer 330 of the organic light-emitting diode OLED may be located within an opening provided by the pixel-defining layer 160. A light-emitting area of an organic light-emitting diode OLED may be defined by the opening.

The intermediate layer 330 may include an emission layer. The emission layer may include an organic material including a fluorescent or phosphorescent material that emits red, green, blue, or white light. The emission layer may include a low-molecular weight organic material or a high-molecular weight organic material, and functional layers, such as a hole transport layer (HTL), a hole injection layer (HIL), an electron transport layer (ETL), and an electron injection layer (ElL), may be selectively arranged below and on the emission layer.

The emission layer may have a shape patterned according to each pixel electrode 310. Layers other than the emission layer included in the intermediate layer 330 may be variously modified, such as being integrated across a plurality of pixel electrodes 310.

The opposing electrode 350 may be a transmissive electrode or a reflective electrode. For example, the opposing electrode 350 may be a transparent or (semi-)transparent electrode, and include a metal thin film with a low work function, including lithium (Li), calcium (Ca), lithium fluoride (LiF), Al, Ag, Mg, or a compound thereof. The opposing electrode 350 may further include a transparent conductive oxide (TCO) layer, such as ITO, IZO, ZnO, or In₂O₃, which is disposed on the metal thin film. The opposing electrode 350 may be integrated throughout the display area DA and disposed on the intermediate layer 330 and the pixel-defining layer 160.

Hereinabove, a configuration of the first pixel PX1 has been mainly described and such descriptions may also be applied to the second pixel PX2 and/or the third pixel PX3.

The organic light-emitting diodes OLED may easily deteriorate due to moisture or oxygen. Accordingly, in order to protect the organic light-emitting diodes OLED from external moisture or oxygen, the display device 10 may include the encapsulation layer 400 covering the organic light-emitting diodes OLED.

The encapsulation layer 400 may include at least one inorganic encapsulation layer and at least one organic encapsulation layer. For example, the encapsulation layer 400 may include a first inorganic encapsulation layer 410, a second inorganic encapsulation layer 430, and an organic encapsulation layer 420 between the first inorganic encapsulation layer 410 and the second inorganic encapsulation layer 430.

The first inorganic encapsulation layer 410 and the second inorganic encapsulation layer 430 may include one or more inorganic insulating materials, such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and zinc oxide (ZnO₂), and may be formed through chemical vapor deposition (CVD) or the like. The organic encapsulation layer 420 may include a polymer-based material. The polymer-based material may include silicon-based resin, acryl-based resin (for example, polymethyl methacrylate or polyacrylic acid), epoxy-based resin, polyimide, or polyethylene.

The touch layer 700 is disposed on the encapsulation layer 400. The touch layer 700 may be arranged directly on the encapsulation layer 400. The touch layer 700 may be formed on the display panel DP through a continuous process. For example, when the touch layer 700 is arranged directly on the display panel DP, an adhesive layer is not provided between the display panel DP and the touch layer 700. However, the disclosure is not necessarily limited thereto, and an adhesive layer may be provided between the display panel DP and the touch layer 700. The adhesive layer has the characteristic of being able to retain its adhesive ability even after being attached and removed. The adhesive layer may be a pressure sensitive adhesive (PSA) that is a semi-fluidic material maintaining a stack structure when the display device is folded and unfolded a plurality of times. In this case, the touch layer 700 may be manufactured through a separate process from the display panel DP and attached to the top surface of the display panel DP by the adhesive layer.

The touch layer 700 may detect an external input, change the external input to a certain input signal, and provide the input signal to the display panel DP. The touch layer 700 may recognize a user's direct touch, the user's indirect touch, a direct touch of an object, or an indirect touch of the object. The touch layer 700 may detect at least one of a location of a touch and intensity (pressure) of the touch applied from the outside. The touch layer 700, according to an embodiment, may have various structures or include various materials, and is not necessarily limited by any one embodiment. The touch layer 700 may include a plurality of detection electrodes 710 for detecting an external input. The detection electrodes 710 may detect the external input in a capacitive manner. The display panel DP may receive an input signal from the touch layer 700 and generate an image corresponding to the input signal.

The color filter layer 800 is disposed on the touch layer 700. The display device 10, according to an embodiment, includes, instead of a polarizer, the color filter layer 800 including an on-cell film (OCF) to which a color filter and a black pixel define layer (BPDL), which serves as light-shielding portion, are applied. The color filter layer 800 may be arranged directly on the touch layer 700. The color filter layer 800 may be formed on the touch layer 700 through a continuous process. For example, the color filter layer 800 may be formed on the touch layer 700 through a low-temperature printing process. For example, when the color filter layer 800 is arranged directly on the touch layer 700, an adhesive layer is not provided between the color filter layer 800 and the touch layer 700.

A pol-less technology (i.e., not using a polarization layer) is applied to the display device 10 according to an embodiment. A polarizing plate of the related art is included in a display device to prevent reflection of external light. An organic light-emitting diode includes a circuit layer configured to drive the organic light-emitting diode, and various wires and TFTs included in the circuit layer use metal materials to improve conductivity. However, metals are highly reflective and shiny. Thus, when looking at the display device under external lighting, it may be difficult to see a screen shaped artifact as external light is reflected by the circuit layer or the like. In this regard, the polarizing plate is included in the display device to prevent reflection of external light. Although the polarizing plate prevent the reflection of external light, the polarizing plate may deteriorate light emission efficiency of the organic light-emitting diode. When light passes through the polarizing plate that is a semi-transparent plastic sheet, brightness is reduced by 50 % or more, and thus, light efficiency is decreased. Increasing brightness at this time requires more power consumption. In addition, increasing brightness leads to a decrease in product life. Thus, according to an embodiment, a polarizing plate is removed from the display device 10 and instead the color filter layer 800 is employed to prevent reflection of external light. Accordingly, colors may be expressed more vividly and power consumption may be reduced.

The color filter layer 800 may include a light-shielding portion 840 and a plurality of color filters, i.e., a first filter 810, a second filter 820, and a third filter 830. The color filter layer 800 may include the first filter 810 transmitting a first color light, the second filter 820 transmitting a second color light, and the third filter 830 transmitting a third color light. For example, the first filter 810 may be a red filter, the second filter 820 may be a green filter, and the third filter 830 may be a blue filter. A color of each filter may match a color of an emission layer of a corresponding pixel.

Each of the first filter 810, the second filter 820, and the third filter 830 may include a polymer photosensitive resin and a pigment or dye. The first filter 810 may include a red pigment or dye, the second filter 820 may include a green pigment or dye, and the third filter 830 may include a blue pigment or dye. An embodiment is not necessarily limited thereto, and at least one filter might not include a pigment or dye. At least one filter may include a polymer photosensitive resin and might not include a pigment or dye. At least one filter may be transparent. At least one filter may include a transparent photosensitive resin.

The light-shielding portion 840 may be a black pixel-defining layer or a black matrix. The light-shielding portion 840 may include an organic light-shielding material or an inorganic light-shielding material, which includes a black pigment or a black dye. The light-shielding portion 840 may prevent light leakage and distinguish boundaries between the adjacent first filter 810, second filter 820, and third filter 830.

The color filter layer 800 may further include a buffer layer 850. The buffer layer 850 may be provided to cover the first filter 810, the second filter 820, the third filter 830, and the light-shielding portion 840. The buffer layer 850 may be a protection layer protecting the first filter 810, the second filter 820, and the third filter 830. The buffer layer 850 may include an inorganic layer including at least one inorganic material among silicon oxide, silicon nitride, and silicon oxynitride. The buffer layer 850 may include a single layer or a plurality of layers.

The cover window CW is disposed on the color filter layer 800. An adhesive layer may be additionally provided between the color filter layer 800 and the cover window CW. The adhesive layer includes an adhesive material that minimizes light loss or reflection and maintains a stack structure when the display device is folded and unfolded a plurality of times. The adhesive layer has the characteristic of being able to retain its adhesive properties even after being attached and removed. The adhesive material may include at least one material from among an acryl-based material, a silicon-based material, and a urethane-based material. The adhesive layer may include a PSA that is a semi-fluidic material maintaining a stack structure when the display device is folded and unfolded a plurality of times.

According to an embodiment, an ultraviolet blocking material may be added to the adhesive layer. The ultraviolet blocking material may include an inorganic chemical material such as zinc oxide (ZnO) and/or titanium dioxide (TiO₂). The ultraviolet blocking material may perform a function of reflecting or scattering ultraviolet rays. As such, the adhesive layer includes the ultraviolet blocking material, and thus, the adhesive layer may have an ultraviolet blocking function. The PSA may serve as a matrix within the adhesive layer, and the ultraviolet blocking material may be (e.g., uniformly) distributed in the PSA. Here, the matrix may represent a medium corresponding to a main component in a layer configuration. The ultraviolet blocking material may be (e.g., uniformly) distributed within the adhesive layer. According to an embodiment, the adhesive layer may transmit 10 % or less ultraviolet rays having a wavelength of 380 nm or less. For example, when the cover window CW includes thin-film glass, the ultraviolet blocking function of the cover window CW may be weak. In this regard, the ultraviolet blocking material is included in the adhesive layer below the cover window CW, and thus, the ultraviolet blocking function may be performed through the adhesive layer.

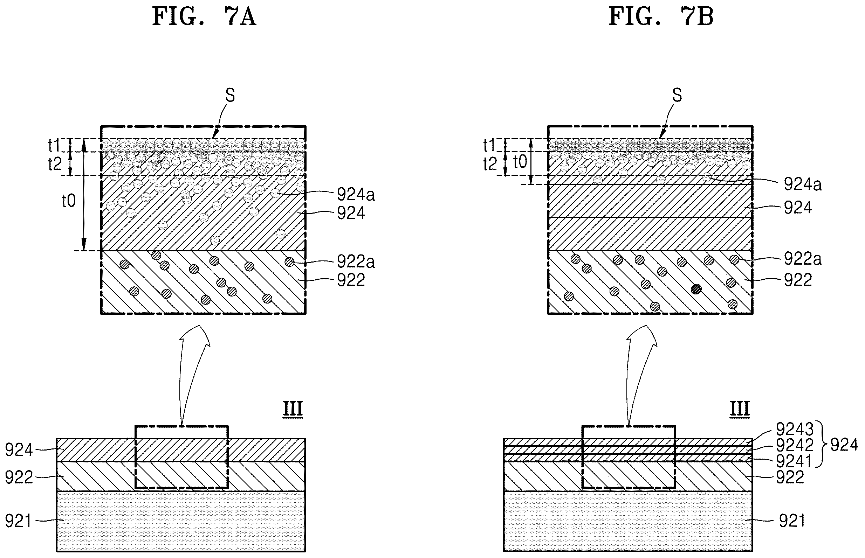

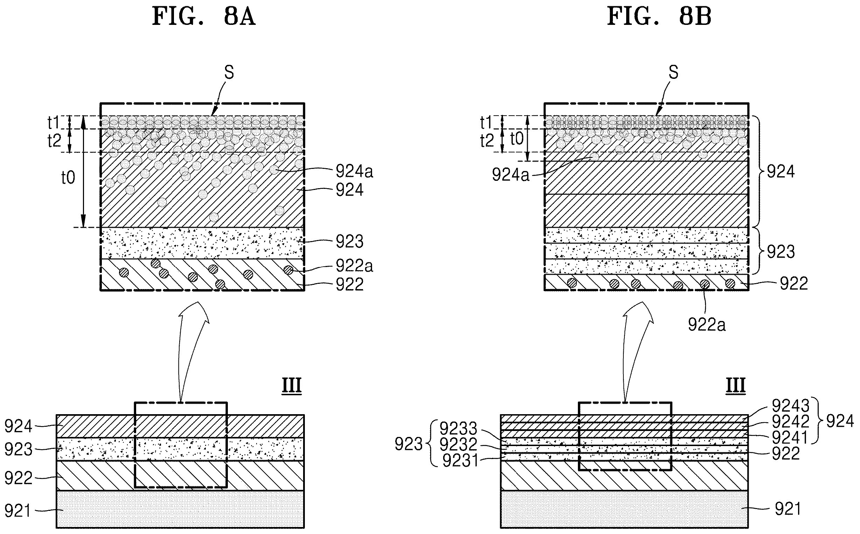

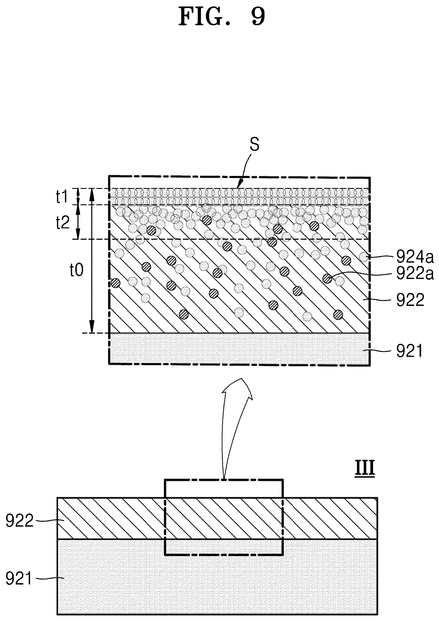

FIGS. 7A and 7B illustrate the cover window CW according to various embodiments, which is an enlarged view of a region III of FIG. 5. FIGS. 8A and 8B illustrate the cover window CW according to various embodiments. FIG. 9 illustrates the cover window CW according to various embodiments. Hereinafter, the cover window CW will be described in detail with reference to FIGS. 7 to 9.

Referring back to FIG. 5, the cover window CW may include a window 910 and a cover layer 920 disposed on the window 910.

The window 910 may include an optically transparent insulating material. Accordingly, an image generated in the display panel DP may be easily recognized by the user through the window 910. The window 910 may include a thin film glass or a synthetic resin film. When the window 910 is a thin film glass, a thickness may be 80 micrometers or less, for example 30 micrometers, but the thickness is not necessarily limited thereto. When the window 910 is a synthetic resin film, the window 910 may include a polyimide (PI) film or a polyethylene terephthalate (PET) film.

The cover layer 920 may be disposed on the window 910 (e.g., directly attached to the window). The cover layer 920 may improve impact resistance of the window 910, prevent reflection of external light, increase wear resistance, and/or protect the display device 10 from external contamination. Here, the cover layer 920 may also be referred to as an optical film. Referring to FIGS. 7 to 9, the cover layer 920 may include a base layer 921 and a functional layer disposed on the base layer 921.

In the present embodiment, the window 910 and the cover layer 920 disposed on the window 910 are described separately. However, this is only an example and the window 910 may be omitted to minimize a thickness of the display device 10. In this case, the cover window CW may indicate only the cover layer 920.

The base layer 921 also provides a surface on which the functional layer is arranged. The base layer 921 may include a polymer material. For example, the base layer 921 may include polyimide, polyacrylate, polymethylmethacrylate (PMMA), polycarbonate (PC), polyethylenenaphthalate (PEN), polyvinylidene chloride, polyvinylidene difluoride (PVDF), polystyrene, an ethylene vinylalcohol copolymer, or a combination thereof. However, the material of the base layer 921 is not necessarily limited to the presented polymer material, and any material that has optical transparency and has a restoring shape even after being folded and unfolded a plurality of times may be used without limitation. A thickness of the base layer 921 may be within a range from about 10 micrometers to about 150 micrometers, inclusive, but the disclosure is not necessarily limited thereto.

According to an embodiment, an ultraviolet blocking material may be added to the base layer 921. The ultraviolet blocking material may include an inorganic chemical material such as zinc oxide (ZnO) and/or titanium dioxide (TiO₂). The ultraviolet blocking material may perform a function of reflecting or scattering ultraviolet rays. The base layer 921 may include the polymer material as a matrix and the ultraviolet blocking material (e.g., uniformly) distributed in the polymer material. As such, the base layer 921 includes the ultraviolet blocking material, and thus, the cover window CW may have an ultraviolet blocking function. According to an embodiment, the base layer 921 may transmit 0 % to 10 % of ultraviolet rays having a wavelength of 380 nm or less. Here, 0 % or more indicates that ultraviolet rays are not transmitted but are reflected or blocked.

The functional layer is disposed on the base layer 921. The functional layer may include a single layer or a plurality of layers.

A thickness of the functional layer may be within a range from about 2 micrometers to about 21 micrometers, inclusive. For example, the thickness of the functional layer may be within a range from about 1.02 micrometers to about 20.5 micrometers, inclusive. When the thickness of the functional layer is less than about 2 micrometers, an intended antireflection function or surface durability function of the functional layer might not be exhibited. In addition, when the thickness of the functional layer is greater than about 21 micrometers, the entire thickness of the display device 10 increases and stress at a folding portion may become severe, thereby deteriorating folding characteristics.

Referring to FIGS. 7A and 7B, the functional layer may include a hard coating layer 922 disposed on the base layer 921 and a refractive layer disposed on the hard coating layer 922.

The hard coating layer 922 may include a hard coating material.

The hard coating material may include a high-strength material having pencil hardness of F or more. As an example of the disclosure, the hard coating material may include a hard coating composition including at least one of an organic composition, an inorganic composition, and an organic-inorganic composition. For example, the hard coating material may include at least one material of siloxane resin, epoxy resin, and acryl-based resin.

Siloxane resin may include silsesquioxane, siloxane compounds, and/or the like.

Epoxy resin may be at least one of glycidyl epoxy resin, cycloaliphatic epoxy resin, and/or oxetane resin.

Acryl-based resin may include bisphenol-A ethylene oxide diacrylate, bisphenol-A ethylene oxide dimethacrylate, bisphenol-A ethoxylate diacrylate, bisphenol-A polyethoxylate diacrylate, bisphenol-A diacrylate, bisphenol-S diacrylate, dicyclopentadienyl diacrylate, pentaerythritol triacrylate, tris(2-hydroxyethyl)isocyanurate triacrylate, tris(2-hydroxyethyl)isocyanurate triacrylate, pentaerythritol tetraacrylate, bisphenol-A dimethacrylate, bisphenol-S dimethacrylate, dicyclopentadienyl dimethacrylate, pentaerythritol trimethacrylate, tris(2-hydroxyethyl)isocyanurate trimethacrylate, and/or pentaerythritol tetramethacrylate.

The hard coating layer 922 may have a thickness within a range from about 1 micrometer to about 20 micrometers, inclusive. For example, a thickness from about 1.9 micrometer to about 19.6 micrometers, and, for example, a thickness from about 1.94 micrometer to 19.58 micrometers. When the thickness of the hard coating layer 922 is more than about 20 micrometers, flexibility may be reduced, and when the thickness of the hard coating layer 922 is less than about 1 micrometer, surface hardness of the hard coating layer 922 may be reduced.

According to an embodiment, the hard coating layer 922 may include the hard coating material and an ultraviolet blocking material 922a. The hard coating layer 922 may have a single layer structure. For example, the hard coating layer 922 includes one layer including the hard coating material and an ultraviolet blocking material 922a.

The ultraviolet blocking material 922a may include inorganic particles such as zinc oxide (ZnO) and/or titanium dioxide (TiO₂). The ultraviolet blocking material 922a may perform a function of reflecting or scattering ultraviolet rays.

The hard coating layer 922 including the hard coating material may serve as a matrix and the ultraviolet blocking material 922a may be (e.g., uniformly) distributed in the hard coating material. However, the disclosure is not necessarily limited thereto and the hard coating material and the ultraviolet blocking material 922a may be (e.g., uniformly) distributed in a separate matrix. In FIGS. 7A and 7B, the ultraviolet blocking material 922a is illustrated as particles with a circular cross-section, but this is only an example and is not an actual shape of the ultraviolet blocking material 922a. FIGS. 7A and 7B may be schematic views of a state in which the hard coating material and the ultraviolet blocking material 922a have solidified and lost fluidity.

In the case that the hard coating layer 922 is provided as a single layer including both the hard coating material and the ultraviolet blocking material 922a, a weight ratio of the ultraviolet blocking material 922a based on the total weight of the hard coating layer 922 may be about 5 wt% to about 15 wt%. When the weight ratio of the ultraviolet blocking material 922a is less than about 5 wt%, an ultraviolet blocking effect may be insignificant, and when the weight ratio of the ultraviolet blocking material 922a is more than about 15 wt%, aggregation of the ultraviolet blocking material 922a may occur within the hard coating layer 922.

The refractive layer may be disposed on the hard coating layer 922. In the aspects of FIGS. 7A and 7B, the refractive layer includes a low refractive layer 924. The low refractive layer 924 may include a low refractive material having a low refractive index and an anti-fingerprint material 924a.

According to the aspects illustrated in FIG. 7A, the refractive layer has a single layer structure including one low refractive layer 924. Also, the low refractive layer 924 is provided as a single integrated layer including the low refractive material and the anti-fingerprint material 924a.

The low refractive layer 924 may include, as the low refractive material, an inorganic material or an organic material having a refractive index within a range from about 1.1 to about 1.9, inclusive. For example, the low refractive material may include a low refractive inorganic material such as lithium fluoride (LiF), magnesium fluoride (MgF₂), aluminum fluoride (AlF₃), and/or sodium fluoride (NaF), or a low refractive organic material such as polytetrafluoroethylene (PTFE), polymethyl methacrylate (PMMA), polydimethylsiloxane (PDMS), and/or perfluoronaphthalene. In addition, the low refractive material may include, but is not necessarily limited to, an amino-based low refractive material such as amino silane or 3-aminopropyltriethoxysilane (APTES), a silane-based low refractive material such as hexamethyldisiloxane (HMDS) or tetraethoxysilane (TEOS), and an acrylate-based low refractive material such as polymethyl methacrylate (PMMA) or fluoroacrylate (FA).

In some aspects, the anti-fingerprint material 924a includes a water-repellent material or an oil-repellent material. The anti-fingerprint material 924a may improve contamination resistance of the cover window CW.

The anti-fingerprint material 924a may include inorganic particles including a fluorine-based material. For example, the anti-fingerprint material 924a may include a fluorinated silane compound in which a silane moiety and a fluorinated carbon moiety are connected by an alkyl chain. The anti-fingerprint material 924a may include an organic material including a fluorine-based material. For example, the anti-fingerprint material 924a may include at least one material of polytetrafluoroethylene (PTFE), fluorinated ethylene propylene (FEP), and/or perfluoropolyether (PFPE).

According to a some embodiments, the anti-fingerprint material 924a may include inorganic particles including a silicon-based material. For example, the anti-fingerprint material 924a may include inorganic particles such as silica nanoparticles (SiO₂). However, the disclosure is not necessarily limited thereto and the anti-fingerprint material 924a may include at least one organic silicon compound of hexamethyldisiloxane (HMDSO), tetraethyl orthosilicate (TEOS), polydimethylsiloxane (PDMS), and/or phenylmethylsilicone.

The low refractive layer 924 may have a surface contact angle from about 100 degrees to about 120 degrees by the anti-fingerprint material 924a. The surface contact angle may vary depending on a weight ratio of the anti-fingerprint material 924a to the low refractive layer 924. According to an embodiment, the anti-fingerprint material 924a may have a weight ratio within a range from about 1 wt% to about 10 wt%, inclusive, based on the total weight of the low refractive layer 924. When the anti-fingerprint material 924a has a weight ratio of less than about 1 wt%, the surface durability of the low refractive layer 924 is not improved. When the anti-fingerprint material 924a has a weight ratio of more than about 10 wt%, the surface hardness of the low refractive layer 924 may be reduced, and subsequent surface reorientation of the fluorine-based material may be hindered.

The low refractive layer 924 may have a thickness within a range from about 10 nanometers to about 250 nanometers, inclusive, for example, about 70 nanometers to about 120 nanometers. When the thickness of the low refractive layer 924 is greater than about 250 nanometers, flexibility may be reduced. When the thickness of the low refractive layer 924 is less than about 10 nanometers, external light reflection might not be sufficiently prevented.

In some aspects, the low refractive layer 924 may include the low refractive material serving as a matrix and the anti-fingerprint material 924a is distributed in the matrix. The anti-fingerprint material 924a may include a fluorine-based material or a silicon-based material, and the fluorine-based material or the silicon-based material is characterized by low surface energy. In addition, the fluorine-based material or the silicon-based material has a characteristic of having a weak interaction with other materials. Accordingly, the anti-fingerprint material 924a floats on a surface within the matrix rather than being uniformly distributed within the matrix, causing surface reorientation (e.g., surface segregation).

The low refractive layer 924 may be formed by coating a solution containing the low refractive material and the anti-fingerprint material 924a on the hard coating layer 922. In this case, after a certain period of time, the anti-fingerprint material 924a floats on the surface of the low refractive layer 924, and surface reorientation occurs in which the density of the anti-fingerprint material 924a is highest on a surface S of the low refractive layer 924 in a thickness direction. Accordingly, the density of the anti-fingerprint material 924a in the low refractive layer 924 is higher in a portion close to the outermost surface S far from the base layer 921 than in a portion of the low refractive layer 924 close to the base layer 921. As described above, a thickness t0 of the low refractive layer 924 may be within a range from about 10 nanometers to about 250 nanometers, inclusive. The density of the anti-fingerprint material 924a may be higher in a region having a thickness t2 from about 5 nanometers to about 125 nanometers from the outermost surface S far from the base layer 921 in a direction of the base layer 921, that is, a region of about 50 % or less of the thickness t0 of the low refractive layer 924, than in remaining regions. For example, a high-density anti-fingerprint material region may be provided in a thickness t1 from about 2 nanometers to about 50 nanometers, i.e., a thickness of about 20 % or less of the thickness t0 of the low refractive layer 924, in the direction of the base layer 921 based on the outermost surface S of the low refractive layer 924. For example, the thickness t1 of the high-density anti-fingerprint material region may be within a range from about 5 nanometers to about 30 nanometers, inclusive. When the thickness t1 is less than about 5 nanometers, the low refractive layer 924 may be easily damaged by external impact or wear. When the thickness t1 is more than about 30 nanometers, optical performance of the low refractive layer 924 may deteriorate and uneven coating may occur on the surface.

The low refractive layer 924 may be formed by coating a solution containing the low refractive material and the anti-fingerprint material 924a on the hard coating layer 922. In this case, after a certain first period of time from a first temperature, the anti-fingerprint material 924a floats on the surface of the low refractive layer 924, and surface reorientation occurs in which the density of the anti-fingerprint material 924a is highest on the surface S of the low refractive layer 924 in the thickness direction. Here, the first period of time may be defined as a time until the low refractive layer 924 has a surface contact angle from about 100 degrees to about 120 degrees. In the case that a high-temperature curing process is performed at a second temperature higher than the first temperature for a second period of time that is longer than the first period of time, the reoriented anti-fingerprint material 924a may be stably fixed. According to some aspects, the reoriented anti-fingerprint material 924a may be fixed by performing a UV curing process for a third period of time that is shorter than the first period of time by using UV rays having a wavelength from about 350 nm to about 370 nm.

According to various aspects illustrated in FIG. 7B, the refractive layer has a stack layer structure including a plurality of low refractive layers, i.e., a first low refractive layer 9241, a second low refractive layer 9242, and a third low refractive layer 9243. Unlike FIG. 7A, FIG. 7B illustrates the low refractive layer 924 having a triple-layered stack structure including the first low refractive layer 9241, the second low refractive layer 9242, and the third low refractive layer 9243 from the base layer 921, but the number of layers is not necessarily limited thereto.

Each low refractive layer may include, as a low refractive material, an inorganic material or an organic material having a refractive index within a range from about 1.1 to about 1.9, inclusive. The low refractive material has been described above, and to the extent that an element is not described in detail with respect to this figure, it may be understood that the element is at least similar to a corresponding element that has been described elsewhere within the present disclosure. However, low refractive layers may have different refractive indices. According to a some aspects, in a stack structure of low refractive layers, refractive indices of the low refractive layers sequentially decrease in a direction away from the base layer 921. For example, the refractive index of the first low refractive layer 9241 closest to the base layer 921 may be greater than the refractive index of the second low refractive layer 9242, and the refractive index of the second low refractive layer 9242 may be greater than the refractive index of the third low refractive layer 9243. Such a stack structure may reduce external light reflectance, increase transmittance of light, and improve visibility of a display even under external lighting. For example, the refractive index of the first low refractive layer 9241 may be within a range of 1.9 to 1.7, inclusive, the refractive index of the second low refractive layer 9242 may be within a range of 1.7 to 1.4, inclusive, and the refractive index of the third low refractive layer 9243 may be within a range of 1.4 to 1.1, inclusive, but the disclosure is not necessarily limited thereto.

In some aspects, in the case that the low refractive layers have a stack structure, only the third (the outermost) low refractive layer 9243 having the outermost surface S farthest from the base layer 921 may include one integrated layer including a low refractive material and an anti-fingerprint material, as exemplarily shown in FIG. 7A. Each of the first low refractive layer 9241 and the second low refractive layer 9242 (e.g., each low refractive layer below the outermost refractive layer) may include a layer including only a low refractive material. Each of the first low refractive layer 9241 and the second low refractive layer 9242 (e.g., each low refractive layer below the outermost refractive layer) may be free of the (an) anti-fingerprint material.

The first low refractive layer 9241 and the second low refractive layer 9242 may include a low refractive material. Each of the first low refractive layer 9241 and the second low refractive layer 9242 may have a thickness within a range from about 3 nanometers to about 83 nanometers, inclusive, i.e., a thickness of about 1/3 of the total thickness of low refractive layers. When the thickness of the first low refractive layer 9241 or the second low refractive layer 9242 is greater than about 83 nanometers, flexibility may be reduced, and when the thickness of the first low refractive layer 9241 or the second low refractive layer 9242 is less than about 3 nanometers, external light reflection might not be sufficiently prevented.

The third low refractive layer 9243 may include the low refractive material and anti-fingerprint material described above and have a same configuration as a low refractive layer described with reference to FIG. 7A, and thus, to the extent that an element is not described in detail with respect to this figure, it may be understood that the element is at least similar to a corresponding element that has been described elsewhere within the present disclosure. The density of the anti-fingerprint material in the third low refractive layer 9243 may be higher in a portion close to the outermost surface S than in a portion close to the second low refractive layer 9242. The thickness t0 of the third low refractive layer 9243 may be within a range from about 3 nanometers to about 83 nanometers, inclusive. The density of the anti-fingerprint material 924a may be higher in a portion having the thickness t2 of about 50 % or less of the thickness t0 of the third low refractive layer 9243 in the direction of the base layer 921 from the outermost surface S far from the base layer 921 than in remaining portions. For example, a high-density anti-fingerprint material region having the thickness t1 of about 20 % or less of the thickness t0 of the third low refractive layer 9243 may be provided in the direction of the base layer 921 based on the outermost surface S of the third low refractive layer 9243.

According to various aspects, the cover window CW of the display device 10 includes one integrated layer including a low refractive material and an anti-fingerprint material. Accordingly, a low refractive layer at the top of the cover window CW may have an anti-fingerprint characteristic, an anti-contamination characteristic, and an anti-external light reflection characteristic.

A polarizing plate is removed from the display device 10, according to an embodiment, and instead the color filter layer 800 is employed to prevent reflection of external light. When the color filter layer 800 is employed, external light reflectance is higher than when a polarizing plate is employed, and a phenomenon in which a displayed image appears bluish may occur. Accordingly, the display device 10 of the disclosure from which the polarizing plate has been removed may include a low refractive layer on an outermost portion of the cover window CW, thereby preventing external light reflection and preventing a displayed image appearing bluish. However, when a low refractive layer is disposed on the outermost portion of the cover window CW and an anti-fingerprint layer is separately coated on a surface, the anti-fingerprint layer may be easily peeled off due to an interaction between the low refractive layer and the anti-fingerprint layer, and the damaged anti-fingerprint layer may significantly reduce visibility. Thus, according to an embodiment, the display device 10 realizes a single layer of the low refractive layer 924 at the outermost portion of the cover window CW by adding the anti-fingerprint material to the low refractive layer 924. According to an embodiment, because the low refractive layer 924 itself has an anti-fingerprint function, a separate surface coating for anti-fingerprint is not required. Accordingly, an anti-fingerprint layer may be prevented from being easily peeled off by a low refractive layer applied to prevent external light reflection in a pol-less display device, and at the same time, display visibility may be improved and poor appearance may be prevented.

Referring to FIGS. 8A and 8B, the functional layer may include the hard coating layer 922 disposed on the base layer 921 and a refractive layer disposed on the hard coating layer 922.

Some aspects of FIGS. 8A and 8B differ from the aspects of FIGS. 7A and 7B in that the refractive layer has a stack structure of a high refractive layer 923 and the low refractive layer 924. The base layer 921, the hard coating layer 922, and the low refractive layer 924 included in the cover window CW of the various aspects of FIGS. 8A and 8B are the same as those described with reference to FIGS. 7A and 7B, and thus, to the extent that an element is not described in detail with respect to this figure, it may be understood that the element is at least similar to a corresponding element that has been described elsewhere within the present disclosure. Hereinafter, the high refractive layer 923 provided between the hard coating layer 922 and the low refractive layer 924 will be mainly described.

According to various aspects illustrated in FIG. 8A, the refractive layer has a stack structure including the high refractive layer 923 and the low refractive layer 924. Here, the low refractive layer 924 is provided as one integrated layer including a low refractive material and an anti-fingerprint material as described above. The high refractive layer 923 includes a layer including a high refractive material.

The high refractive layer 923 may include, as the high refractive material, an inorganic material or an organic material having a refractive index within a range from about 2.0 to about 2.9, inclusive. For example, the high refractive material may include a high refractive inorganic material such as titanium dioxide (TiO₂), zirconium oxide (ZrO₂), silicon carbide (SiC), zinc sulfide (ZnS), and/or titanium carbide (TiC), or a high refractive organic material such as polyimide and/or polythiophene.

The high refractive layer 923 may have a thickness within a range from about 10 nanometers to about 250 nanometers, inclusive, for example, from about 70 nanometers to about 120 nanometers. When the thickness of the high refractive layer 923 is greater than about 250 nanometers, flexibility may deteriorate, and when the thickness of the high refractive layer 923 is less than about 10 nanometers, surface radiation might not be sufficiently prevented.

According to various aspects illustrated in FIG. 8B, the refractive layer may have a stack structure including a plurality of high refractive layers, i.e., a first high refractive layer 9231, a second high refractive layer 9232, and a third high refractive layer 9233, and a plurality of low refractive layers, i.e., the first low refractive layer 9241, the second low refractive layer 9242, and the third low refractive layer 9243. Unlike FIG. 8A, FIG. 8B illustrates the high refractive layer 923 having a triple-layered stack structure including the first high refractive layer 9231, the second high refractive layer 9232, and the third high refractive layer 9233 from the base layer 921, but the number of layers is not necessarily limited thereto.

Each high refractive layer may include, as a high refractive material, an inorganic material or an organic material having a refractive index within a range from about 2.0 to about 2.9, inclusive. However, high refractive layers may have different refractive indices. According to some aspects, in a stack structure of high refractive layers, refractive indices of the high refractive layers sequentially decrease in a direction away from the base layer 921. For example, the refractive index of the first high refractive layer 9231 closest to the base layer 921 may be greater than the refractive index of the second high refractive layer 9232, and the refractive index of the second high refractive layer 9232 may be greater than the refractive index of the third high refractive layer 9233. Such a stack structure may reduce external light reflectance, increase light transmittance, and improve visibility of a display even under external lighting. For example, the refractive index of the first high refractive layer 9231 may be within a range of 2.9 to 2.7, inclusive, the refractive index of the second high refractive layer 9232 may be within a range of 2.7 to 2.4, inclusive, and the refractive index of the third high refractive layer 9233 may be within a range of 2.4 to 2.1, inclusive, but the disclosure is not necessarily limited thereto.

According to various aspects illustrated in FIGS. 8A and 8B, the functional layer may include a high refractive layer in addition to a low refractive layer, so that when light passes through each refractive layer through a stack structure having different refractive indices, reflection occurring in each layer may be further reduced. Accordingly, transmittance of an image of the display device 10 may be improved and reflection of external light may be effectively prevented.

Referring to FIG. 9, the functional layer may include the hard coating layer 922 disposed on the base layer 921.

Some aspects of FIG. 9 differ from the some aspects of FIGS. 7A, 7B, 8A and 8B in that the functional layer of FIG. 9 includes only the hard coating layer 922 unlike the functional layers of FIGS. 7A, 7B, 8A, and 8B, which further include a refractive layer. The base layer 921 included in the cover window CW of the embodiment of FIG. 9 is the same as that described with reference to FIGS. 7A and 7B, and thus, to the extent that an element is not described in detail with respect to this figure, it may be understood that the element is at least similar to a corresponding element that has been described elsewhere within the present disclosure. Hereinafter, the hard coating layer 922 included in the embodiment of FIG. 9 will be described.

Referring to FIG. 9, the functional layer may include only the hard coating layer 922 disposed on the base layer 921. The functional layer may be free of low refractive layer and/or high refractive layers.

The hard coating layer 922 may include the hard coating material and the anti-fingerprint material 924a. The hard coating layer 922 may include the hard coating material, the anti-fingerprint material 924a, and the ultraviolet blocking material 922a.

The hard coating material may include a high-strength material having pencil hardness of F or more. As an example of the disclosure, the hard coating material may include at least one of a siloxane resin, an epoxy resin, and/or an acryl-based resin. Details about the hard coating material have been described with reference to FIGS. 7A and 7B, and thus, to the extent that an element is not described in detail with respect to this figure, it may be understood that the element is at least similar to a corresponding element that has been described elsewhere within the present disclosure.

The ultraviolet blocking material 922a may include an inorganic chemical material such as zinc oxide (ZnO) and/or titanium dioxide (TiO₂). The ultraviolet blocking material 922a may perform a function of reflecting or scattering ultraviolet rays. Details about the ultraviolet blocking material 922a have been described with reference to FIGS. 7A and 7B, and thus, to the extent that an element is not described in detail with respect to this figure, it may be understood that the element is at least similar to a corresponding element that has been described elsewhere within the present disclosure.

The anti-fingerprint material 924a may include a water-repellent material or an oil-repellent material. The anti-fingerprint material 924a improves contamination resistance of the cover window CW. The anti-fingerprint material 924a may include a fluorine-based material or a silicon-based material. Details about the anti-fingerprint material 924a have been described with reference to FIGS. 7A and 7B, and thus, to the extent that an element is not described in detail with respect to this figure, it may be understood that the element is at least similar to a corresponding element that has been described elsewhere within the present disclosure.

The hard coating layer 922 may have a thickness within a range from about 1 micrometer to about 20 micrometers, inclusive, for example, about 2 micrometers to about 10 micrometers. When the thickness of the hard coating layer 922 is more than about 20 micrometers, flexibility may be reduced, and when the thickness of the hard coating layer 922 is less than about 1 micrometer, surface hardness of the hard coating layer 922 may be reduced.

The hard coating layer 922 include the hard coating material serving as a matrix and the anti-fingerprint material 924a (e.g., uniformly, e.g., with a gradient) distributed in the hard coating material serving as the matrix. Here, the matrix may represent a medium corresponding to a main component in a layer configuration. The density of the anti-fingerprint material 924a in the hard coating layer 922 may be higher in a portion close to the outermost surface S far from the base layer 921 than in a lower portion of the hard coating layer 922 close to the base layer 921. For example, the thickness t0 of the hard coating layer 922 may be within a range from about 1 micrometer to about 20 micrometers, inclusive. The density of the anti-fingerprint material 924a may be higher in a portion having the thickness t2 of about 50 % or less of the thickness t0 of the hard coating layer 922 in the direction of the base layer 921 from the outermost surface S far from the base layer 921 than in remaining portions. For example, a high-density anti-fingerprint material region having the thickness t1 of about 20 % or less of the thickness t0 of the hard coating layer 922 may be provided in the direction of the base layer 921 based on the outermost surface S of the hard coating layer 922.

The hard coating layer 922 may have a surface contact angle within a range from about 100 degrees to about 120 degrees, inclusive, by the anti-fingerprint material 924a. The surface contact angle may vary depending on a weight ratio of the anti-fingerprint material 924a to the hard coating layer 922. According to an embodiment, the anti-fingerprint material 924a may have a weight ratio within a range from about 0 wt% to about 10 wt%, inclusive, based on the total weight of the hard coating layer 922. When the anti-fingerprint material 924a has a weight ratio greater than about 10 wt%, the surface hardness of the hard coating layer 922 may deteriorate.

According to various aspects, the hard coating layer 922 may further include the anti-fingerprint material 924a in addition to the hard coating material and an ultraviolet blocking material 922a. The hard coating layer 922 may have a single layer structure. For example, the hard coating layer 922 may include one layer including the hard coating material, the ultraviolet blocking material 922a, and the anti-fingerprint material 924a.

The hard coating layer 922 include the hard coating material serving as a matrix, and the ultraviolet blocking material 922a and the anti-fingerprint material 924a (e.g., uniformly, e.g., with a gradient) distributed in the hard coating material serving as the matrix. However, the disclosure is not necessarily limited thereto and the hard coating material, the ultraviolet blocking material 922a, and the anti-fingerprint material 924a may be (e.g., uniformly or non-uniformly) distributed in a separate matrix. In this case as well, the density of the anti-fingerprint material 924a in the hard coating layer 922 is higher in the portion close to the outermost surface S far from the base layer 921 than in the lower portion of the hard coating layer 922 close to the base layer 921. To the extent that an element is not described in detail with respect to this figure, it may be understood that the element is at least similar to a corresponding element that has been described elsewhere within the present disclosure.

According to some aspects, the hard coating layer 922 of the cover window CW of the display device 10 includes one (e.g., only one) layer including the ultraviolet blocking material 922a and the anti-fingerprint material 924a. Accordingly, the cover window CW may have a minimum thickness while having an ultraviolet blocking characteristic, an anti-fingerprint characteristic, an anti-contamination characteristic, and an anti-external light reflection characteristic.

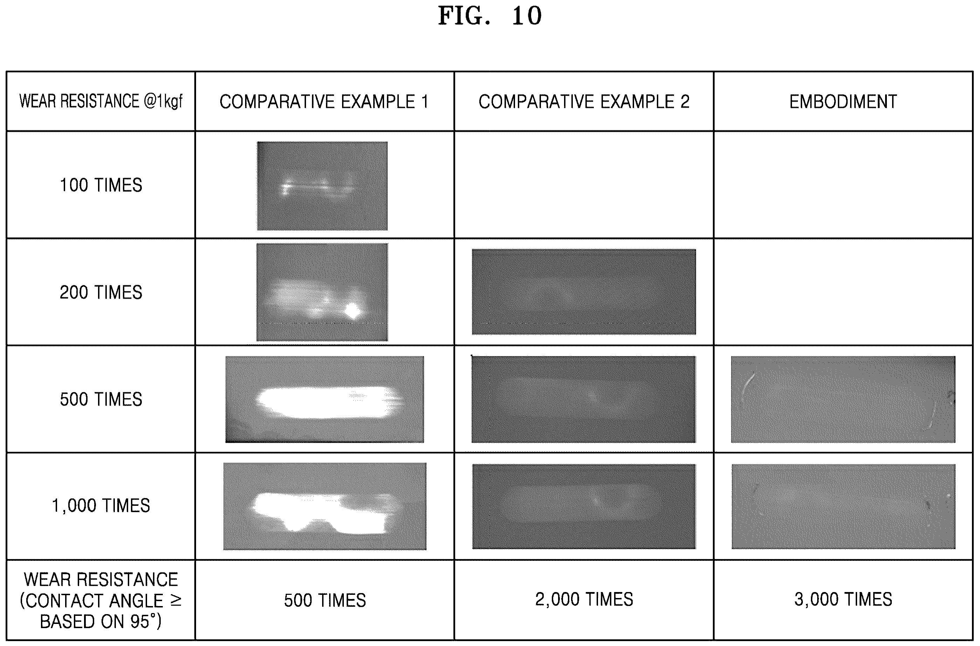

FIG. 10 is a graph illustrating experiment results obtained by comparing wear resistance of a display device according to an embodiment with wear resistance of comparative examples. Effects of the disclosure will be described with reference to FIG. 10.

In Comparative Examples 1 and 2, a functional layer of a cover window of a display device includes a low refractive layer and an anti-fingerprint layer provided through a separate coating on the low refractive layer. For example, in Comparative Examples 1 and 2, the anti-fingerprint layer provided through a separate coating is disposed on an outermost surface of the display device.

In the embodiment, as described with reference to FIGS. 7A, 7B, 8A, and 8B, a functional layer of a cover window of the display device includes a low refractive layer, and the low refractive layer includes one layer of a low refractive material and an anti-fingerprint material. For example, in the embodiment, one low refractive layer including the anti-fingerprint material is disposed on an outermost surface of the display device.

Experiments have been performed to measure wear resistance by repeatedly rubbing surfaces of the cover windows of Comparative Example 1, Comparative Example 2, and the embodiment with a 1 kgf industrial rubber eraser 200 times, 500 times, and 1000 times.

In Comparative Example 1, it is identified that the anti-fingerprint layer was peeled off after 200 repeated rubs, and in Comparative Example 2, it is identified that the anti-fingerprint layer was peeled off after 2000 repeated rubs. However, in the embodiment, only slight discoloration was observed even after 3,000 repeated rubs, and no peeling issue was observed, confirming that wear resistance is greatly improved.

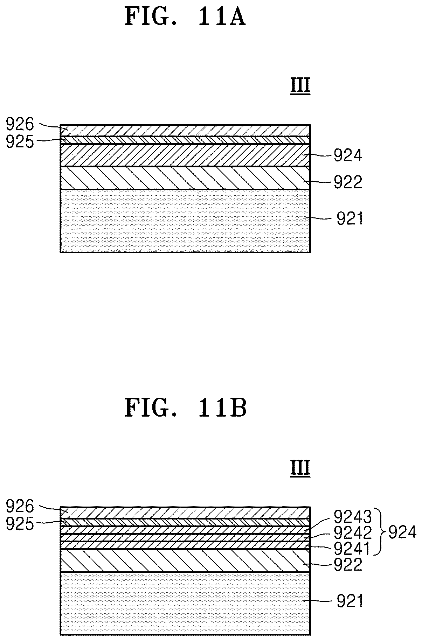

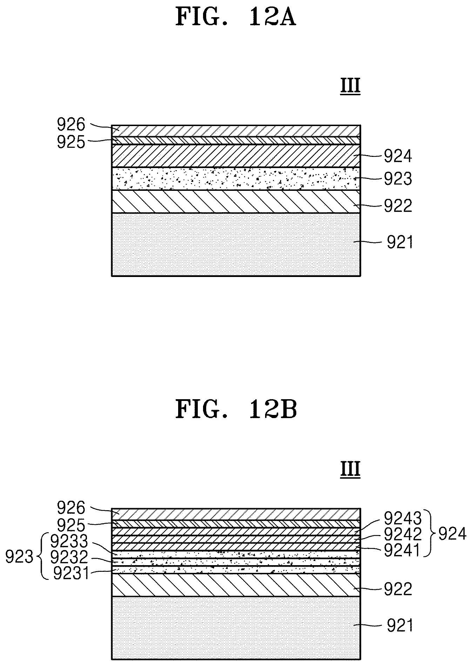

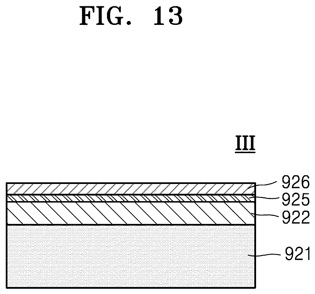

FIGS. 11A and 11B illustrate the cover window CW according to various aspects, which is an enlarged view of the region III of FIG. 5. FIGS. 12A and 12B illustrate the cover window CW according to an embodiment. FIG. 13 illustrates the cover window CW according to various aspects.

Some aspects of FIGS. 11A, 11B, 12A, 12B, and 13 are distinguished from the aspects of FIGS. 7A, 7B, 8A, 8B, and 9 in that the cover window CW includes a separate anti-fingerprint layer 926. In addition, in the embodiments of FIGS. 11A, 11B, 12A, 12B, and 13, a primer layer 925 is provided between the anti-fingerprint layer 926 and a certain functional layer (particularly a refractive layer and/or a hard coating layer) to improve adhesion between the anti-fingerprint layer 926 and the functional layer below the anti-fingerprint layer 926. The base layer 921, the hard coating layer 922, the high refractive layer 923, and the low refractive layer 924 included in the embodiments of FIGS. 11A, 11B, 12A, 12B, and 13 are the same as those described with reference to the embodiments of FIGS. 7A, 7B, 8A, 8B, and 9, and thus, to the extent that an element is not described in detail with respect to this figure, it may be understood that the element is at least similar to a corresponding element that has been described elsewhere within the present disclosure.

Referring to FIGS. 11A and 11B, the functional layer may include the hard coating layer 922 disposed on the base layer 921, the refractive layer disposed on the hard coating layer 922, and the anti-fingerprint layer 926 disposed on the refractive layer. Also, the functional layer may further include the primer layer 925 arranged between the refractive layer and the anti-fingerprint layer 926.

The refractive layer is disposed on the hard coating layer 922. The refractive layer may include the low refractive layer 924 of a single structure or a stack structure. The low refractive layer 924 may include a low refractive material having a low refractive index, and because the thicknesses of the low refractive material and the low refractive layer 924 have been described with reference to FIGS. 7A and 7B, to the extent that an element is not described in detail with respect to this figure, it may be understood that the element is at least similar to a corresponding element that has been described elsewhere within the present disclosure. Unlike the embodiments of FIGS. 7A and 7B, the low refractive layer 924 of FIGS. 11A and 11B might not include an anti-fingerprint material.

According to various aspects illustrated in FIG. 11A, the refractive layer may have a single layer structure including one low refractive layer 924, and according to various aspects illustrated in FIG. 11B, the refractive layer may have a stack structure including a plurality of low refractive layers, i.e., the first low refractive layer 9241, the second low refractive layer 9242, and the third low refractive layer 9243. Unlike FIG. 11A, FIG. 11B illustrates the low refractive layer 924 having a triple-layered stack structure including the first low refractive layer 9241, the second low refractive layer 9242, and the third low refractive layer 9243 from the base layer 921, but the number of layers is not necessarily limited thereto.

In some aspects, the primer layer 925 is disposed on the low refractive layer 924. The primer layer may be arranged between the low refractive layer 924 and the anti-fingerprint layer 926 to improve the adhesion between the two layers. Accordingly, the anti-fingerprint layer 926 may be prevented from being easily peeled off. The primer layer 925 includes a primer material, and the primer material may include at least one material selected from a group consisting of a silane-based material, an acrylate-based material, and an epoxy-based material.

The silane-based material may include methoxysilane and/or ethoxysilane. The acrylate-based material may include methylmethacrylate (MMA). The epoxy-based material may include bisphenol, but this is only an example and the disclosure is not necessarily limited thereto. Such a primer material may induce chemical bonding between the low refractive material included in the low refractive layer 924 and the anti-fingerprint material of the anti-fingerprint layer 926, thereby improving the adhesion between the low refractive layer 924 and the anti-fingerprint layer 926.

The primer layer 925 may have a thickness within a range from about 5 nanometers to about 30 nanometers, inclusive. When the thickness of the primer layer 925 is less than about 5 nanometers, the adhesion between the low refractive layer 924 and the anti-fingerprint layer 926 may not be prevented from deteriorating. When the thickness of the primer layer 925 is greater than about 30 nanometers, the overall thickness increases and stress at a folding portion becomes severe, thereby deteriorating folding characteristics.

The anti-fingerprint layer 926 may be disposed on the primer layer 925. The anti-fingerprint layer 926 includes an anti-fingerprint material. The anti-fingerprint material may include a water-repellent material or an oil-repellent material. The anti-fingerprint material improves the contamination resistance of the cover window CW. The anti-fingerprint material may include a fluorinated silane compound in which a silane moiety and a fluorinated carbon moiety are connected by an alkyl chain. However, the disclosure is not necessarily limited thereto and the anti-fingerprint material may include a fluorine-based material or a silicon-based material.

The fluorine-based material may include at least one material of fluorinated silane compounds, polytetrafluoroethylene (PTFE), fluorinated ethylene propylene (FEP), and/or perfluoropolyether (PFPE).

The silicon-based material may include at least one material of silica nanoparticles (SiO₂), hexamethyldisiloxane (HMDSO), tetraethyl orthosilicate (TEOS), polydimethylsiloxane (PDMS), and/or phenylmethylsilicone.

The anti-fingerprint layer 926 may have a surface contact angle within a range from about 100 degrees to about 120 degrees, inclusive, by the anti-fingerprint material.

The anti-fingerprint layer 926 may have a thickness within a range from about 5 nanometers to about 30 nanometers, inclusive. When the thickness of the anti-fingerprint layer 926 is less than about 5 nanometers, the anti-fingerprint layer 926 may be easily damaged by external impact or wear. When the thickness of the anti-fingerprint layer 926 is greater than about 30 nanometers, flexibility may be reduced.

The anti-fingerprint layer 926 may be formed on the primer layer 925 through spin coating.

In some aspects, referring to FIGS. 12A and 12B, the functional layer may include the hard coating layer 922 disposed on the base layer 921, the refractive layer disposed on the hard coating layer 922, the primer layer 925 disposed on the refractive layer, and the anti-fingerprint layer 926 disposed on the refractive layer.

Some aspects of FIGS. 12A and 12B differ from the aspects of FIGS. 11A and 11B in that the refractive layer has a stack structure of the high refractive layer 923 and the low refractive layer 924. The base layer 921, the hard coating layer 922, and the low refractive layer 924 included in the cover window CW of the aspects of FIGS. 12A and 12B are the same as those described with reference to FIGS. 7A, 7B, 8A, 8B, 9, 10, and 11, and thus, to the extent that an element is not described in detail with respect to this figure, it may be understood that the element is at least similar to a corresponding element that has been described elsewhere within the present disclosure. In addition, the high refractive layer 923 arranged between the hard coating layer 922 and the low refractive layer 924 is the same as that described with reference to FIGS. 8A and 8B, and thus to the extent that an element is not described in detail with respect to this figure, it may be understood that the element is at least similar to a corresponding element that has been described elsewhere within the present disclosure.

The primer layer 925 may be disposed on the low refractive layer 924. Descriptions about the primer layer 925 are the same as those of the embodiment of FIGS. 11A and 11B, and thus, to the extent that an element is not described in detail with respect to this figure, it may be understood that the element is at least similar to a corresponding element that has been described elsewhere within the present disclosure. The anti-fingerprint layer 926 may be disposed on the primer layer 925. Descriptions about the anti-fingerprint layer 926 are the same as those of the aspects of FIGS. 11A and 11B, and thus, to the extent that an element is not described in detail with respect to this figure, it may be understood that the element is at least similar to a corresponding element that has been described elsewhere within the present disclosure.

In some aspects, referring to FIG. 13, the functional layer may include the hard coating layer 922 disposed on the base layer 921, the primer layer 925 disposed on the hard coating layer 922, and the anti-fingerprint layer 926 disposed on the primer layer 925.

Some aspects of FIG. 13 differs from the aspects of FIGS. 11A, 11B, 12A, and 12B in that the functional layer of FIG. 13 includes only the hard coating layer 922 unlike the functional layers of FIGS. 11A, 11B, 12A, and 12B, which further include a refractive layer. The base layer 921 included in the cover window CW of the aspects of FIG. 13 is the same as that described with reference to FIGS. 7A and 7B, and thus, to the extent that an element is not described in detail with respect to this figure, it may be understood that the element is at least similar to a corresponding element that has been described elsewhere within the present disclosure. In addition, the hard coating layer 922 included in the aspects of FIG. 13 is also the same as that described with reference to FIGS. 7A and 7B, and thus, to the extent that an element is not described in detail with respect to this figure, it may be understood that the element is at least similar to a corresponding element that has been described elsewhere within the present disclosure.

The primer layer 925 is disposed on the hard coating layer 922. Descriptions about the primer layer 925 are the same as those of the aspects of FIGS. 11A and 11B, and thus, to the extent that an element is not described in detail with respect to this figure, it may be understood that the element is at least similar to a corresponding element that has been described elsewhere within the present disclosure. The anti-fingerprint layer 926 is disposed on the primer layer 925. Descriptions about the anti-fingerprint layer 926 are the same as those of the aspects of FIGS. 11A and 11B, and thus, to the extent that an element is not described in detail with respect to this figure, it may be understood that the element is at least similar to a corresponding element that has been described elsewhere within the present disclosure.

The display device 10, according to an embodiment, may be manufactured through following manufacturing process. Referring to FIGS. 5 and 6, the substrate 100 is prepared and the display panel DP is manufactured on the substrate 100. The touch layer 700 is provided on the display panel DP. The touch layer 700 may be disposed on the encapsulation layer 400 through a consecutive process. Then, the color filter layer 800 is provided on the touch layer 700. The color filter layer 800 may be disposed on the touch layer 700 through a consecutive process. Next, the cover window CW may be adhered onto the color filter layer 800 through an adhesive layer.

The cover window CW may be manufactured through a separate process. Hereinafter, a manufacturing process of the cover window CW according to the embodiment of FIG. 7A will be described. Selectively, the cover window CW may be manufactured by forming a cover layer on a window including a thin film glass. However, the disclosure is not necessarily limited to the window and may be omitted. The cover layer is formed by first preparing the base layer 921, spin-coating, on the base layer 921, a solution containing the ultraviolet blocking material 922a added to the hard coating material, and then curing the solution to form the hard coating layer 922. Then, a solution containing a low refractive material and an anti-fingerprint material is spin-coated on the hard coating layer 922 to form the low refractive layer 924. Next, after the certain first period of time from the first temperature, the anti-fingerprint material 924a floats on the surface of the low refractive layer 924, and surface reorientation occurs in which the density of the anti-fingerprint material 924a is highest on the surface S of the low refractive layer 924 in the thickness direction. Here, the first period of time may be defined as a time until the low refractive layer 924 has a surface contact angle within a range from about 100 degrees to about 120 degrees, inclusive. In the case that a high-temperature curing process is performed at the second temperature higher than the first temperature for the second period of time that is longer than the first period of time, the reoriented anti-fingerprint material 924a may be stably fixed. According to a selective embodiment, the reoriented anti-fingerprint material 924a may be fixed by performing a UV curing process for the third period of time that is shorter than the first period of time by using UV rays having a wavelength within a range from about 350 nm to about 370 nm, inclusive.

The display device 10 described in the above embodiments may be applied to an electronic device as a display module.

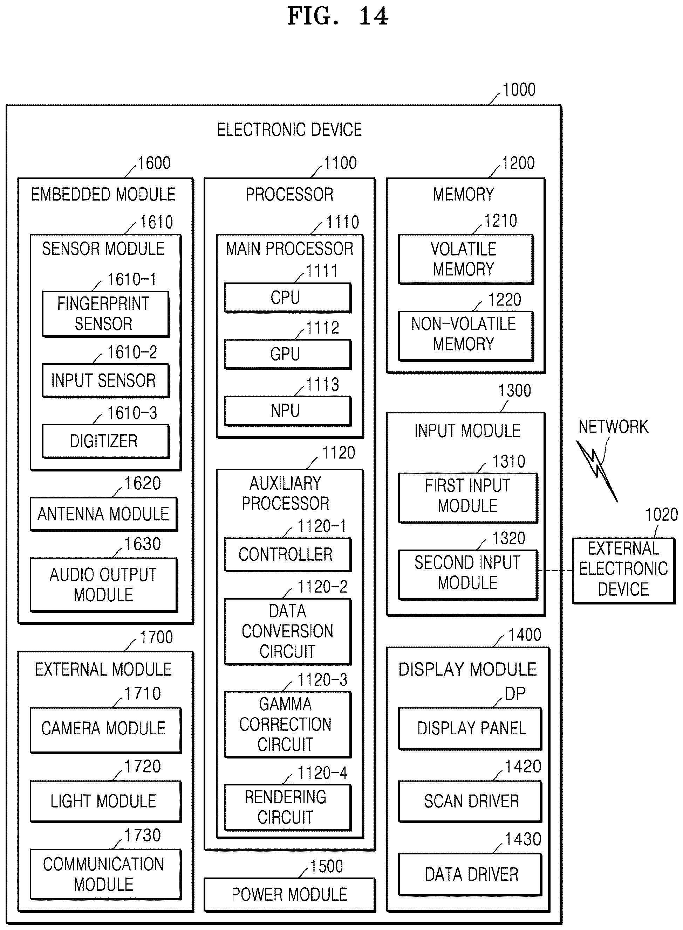

FIG. 14 is a block diagram of an electronic device 1000 according to an embodiment.

The electronic device 1000 outputs various types of information through a display module 1400 within an operating system. Here, the display module 1400 may correspond to the display device 10 according to embodiments described above. When a processor 1100 executes an application stored in a memory 1200, the display module 1400 provides application information to a user through the display panel DP.

The processor 1100 obtains an external input through an input module 1300 or a sensor module 1610, and executes an application corresponding to the external input. For example, when the user selects a camera icon displayed on the display panel DP, the processor 1100 obtains a user input through an input sensor 1610-2 and activates a camera module 1710. The processor 1100 transmits image data corresponding to a captured image obtained through the camera module 1710 to the display module 1400. The display module 1400 may display an image corresponding to the captured image through the display panel DP.

In an example, when personal information authentication is performed in the display module 1400, a fingerprint sensor 1610-1 obtains input fingerprint information as input data. The processor 1100 compares the input data obtained through the fingerprint sensor 1610-1 with authentication data stored in the memory 1200 and executes an application based on a comparison result. The display module 1400 may display information executed according to logic of the application through the display panel DP.

In an example, when a music streaming icon displayed on the display module 1400 is selected, the processor 1100 obtains a user input through the input sensor 1610-2 and activates a music streaming application stored in the memory 1200. When a music execution command is input to the music streaming application, the processor 1100 activates an audio output module 1630 to provide the user with audio information corresponding to the music execution command.

Hereinabove, operations of the electronic device 1000 have been briefly described. Hereinafter, a configuration of the electronic device 1000 will be described in detail. Some of components of the electronic device 1000 described below may be integrated and provided as one component, or one component may be provided by being separated into two or more components.

Referring to FIG. 14, the electronic device 1000 may communicate with an external electronic device 1020 through a network (e.g., a short-range wireless communication network or a long-range wireless communication network). According to an embodiment, the electronic device 1000 may include the processor 1100, the memory 1200, the input module 1300, the display module 1400, a power module 1500, an embedded module 1600, and an external module 1700. According to an embodiment, in the electronic device 1000, at least one of the above components may be omitted or one or more other components may be added. According to an embodiment, some of the components described above (e.g., the sensor module 1610, an antenna module 1620, or the audio output module 1630) may be integrated into another component (e.g., the display module 1400).

The processor 1100 may execute software to control at least one other component (e.g., a hardware or software component) of the electronic device 1000 connected to the processor 1100 and perform various data processes or operations. According to an embodiment, as at least a part of the data processes or operations, the processor 1100 may store, in a volatile memory 1210, a command or data received from another component (e.g., the input module 1300, the sensor module 1610, or a communication module 1730), process the command or data stored in the volatile memory 1210, and store result data in a non-volatile memory 1220

The processor 1100 may include a main processor 1110 and an auxiliary processor 1120. The main processor 1110 may include at least one of a central processing unit (CPU) 1111 or an application processor (AP). The main processor 1110 may further include at least one of a graphics processing unit (GPU) 1112, a communication processor (CP), and an image signal processor (ISP). The main processor 1110 may further include a neural processing unit (NPU) 1113. The NPU 1113 is a processor specialized in processing an artificial intelligence model, and the artificial intelligence model may be generated through machine learning. The artificial intelligence model may include a plurality of artificial neural network layers. An artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination thereof, but is not necessarily limited thereto. The artificial intelligence model may include, additionally or alternatively, a software structure, in addition to a hardware structure. The processor 1100 may be implemented as a configuration (e.g., a single chip) in which at least two of the above-described processing units and processors are integrated, or implemented as configurations (e.g., a plurality of chips) in which the above-described processing units and processors are independent.

The auxiliary processor 1120 may include a controller 1120-1. The controller 1120-1 may include an interface conversion circuit and a timing control circuit. The controller 1120-1 receives an image signal from the main processor 1110 and outputs image data by converting a data format of the image signal according to an interface specification of the display module 1400. The controller 1120-1 may output various control signals required to drive the display module 1400. For example, the controller 1120-1 may generate a scan input signal.

The auxiliary processor 1120 may further include a data conversion circuit 1120-2, a gamma correction circuit 1120-3, and a rendering circuit 1120-4. The data conversion circuit 1120-2 receives image data from the controller 1120-1, and may compensate the image data so that an image is displayed at desired brightness according to characteristics of the electronic device 1000 or user settings or may convert the image data to reduce power consumption or compensate for afterimages. The gamma correction circuit 1120-3 may convert image data or a gamma reference voltage so that an image displayed on the electronic device 1000 has desired gamma characteristics. The rendering circuit 1120-4 receives image data from the controller 1120-1 and may render the image data in consideration of a pixel arrangement of the display panel DP applied to the electronic device 1000. At least one of the data conversion circuit 1120-2, the gamma correction circuit 1120-3, and the rendering circuit 1120-4 may be integrated into another component (e.g., the main processor 1110 or the controller 1120-1). At least one of the data conversion circuit 1120-2, the gamma correction circuit 1120-3, and the rendering circuit 1120-4 may be integrated into a data driver 1430 described below.

The memory 1200 may store various pieces of data used by at least one component of the electronic device 1000 (e.g., the processor 1100 or the sensor module 1610), and input data or output data for a command related to the various pieces of data. The memory 1200 may include at least one of the volatile memory 1210 and the non-volatile memory 1220.

The input module 1300 may receive a command or data to be used in a component of the electronic device 1000 (e.g., the processor 1100, the sensor module 1610, or the audio output module 1630) from an external source of the electronic device 1000 (e.g., the user or the external electronic device 1020).

The input module 1300 may include a first input module 1310 into which a command or data is input from the user and a second input module 1320 into which a command or data is input from the external electronic device 1020. The first input module 1310 may include a microphone, a mouse, a keyboard, a key (e.g., a button), or a pen (e.g., a passive pen or an active pen). The second input module 1320 may support a designated protocol for a wired or wireless connection with the external electronic device 1020. According to an embodiment, the second input module 1320 may include a high-definition multimedia interface (HDMI), a universal serial bus (USB) interface, a secure digital (SD) card interface, or an audio interface. The second input module 1320 may include a connector for a physical connection with the external electronic device 1020, for example, an HDMI connector, a USB connector, an SD card connector, or an audio connector (e.g., a headphone connector).

The display module 1400 provides visual information to the user. The display module 1400 may include the display panel DP, a scan driver 1420, and the data driver 1430. The display module 1400 may further include a window, a chassis, and a bracket to protect the display panel DP.

The display panel DP may include a liquid crystal display panel, an organic light-emitting display panel, or an inorganic light-emitting display panel, and the type of the display panel DP is not particularly limited. The display panel DP may be a rigid type or a flexible type that is rollable or foldable. The display module 1400 may further include a supporter, a bracket, or a heat dissipation member that supports the display panel DP.

The scan driver 1420 may be mounted on the display panel DP, as a driving chip. Also, the scan driver 1420 may be integrated into the display panel DP. For example, the scan driver 1420 may include an amorphous silicon thin-film transistor (TFT) gate (ASG) driver circuit, a low temperature polycrystalline silicon (LTPS) TFT gate driver circuit, or an oxide semiconductor TFT gate (OSG) driver circuit, which is embedded in the display panel DP. The scan driver 1420 receives a control signal from the controller 1120-1 and outputs scan signals to the display panel DP in response to the control signal. For example, the scan driver 1420 may receive a scan input signal from the controller 1120-1, receive a scan input voltage from the power module 1500, and output a scan signal to a pixel circuit.

The display panel DP may further include a light-emitting driver. The light-emitting driver outputs an emission control signal to the display panel DP in response to a control signal received from the controller 1120-1. The light-emitting driver may be provided separately from the scan driver 1420 or may be integrated into the scan driver 1420.

The data driver 1430 receives a control signal from the controller 1120-1, converts image data into analog voltages (e.g., data voltages) in response to the control signal, and then outputs the data voltages to the display panel DP.

The data driver 1430 may be integrated into another component (e.g., the controller 1120-1). Functions of the interface conversion circuit and timing control circuit of the controller 1120-1 described above may be integrated into the data driver 1430.

The display module 1400 may further include the light-emitting driver and a voltage generation circuit. The voltage generation circuit may output various voltages required to drive the display panel DP.

The power module 1500 supplies power to components of the electronic device 1000. The power module 1500 may include a battery for charging a power voltage. The battery may include a non-rechargeable primary battery, a rechargeable secondary battery, or a fuel cell. The power module 1500 may include a power management integrated circuit (PMIC). The PMIC supplies optimized power for each of modules described above and below. The power module 1500 may include a wireless power transmission/reception member electrically connected to the battery. The wireless power transmission/reception member may include a plurality of coil-shaped antenna radiators. The power module 1500 may generate a scan input voltage.

The electronic device 1000 may further include the embedded module 1600 and the external module 1700. The embedded module 1600 may include the sensor module 1610, the antenna module 1620, and the audio output module 1630. The external module 1700 may include the camera module 1710, a lights module 1720, and the communication module 1730.

The sensor module 1610 may detect an input by the user's body or an input by a pen among the first input module 1310 and generate an electric signal or data value corresponding to the input. The sensor module 1610 may include at least one of the fingerprint sensor 1610-1, the input sensor 1610-2, and a digitizer 1610-3.

The fingerprint sensor 1610-1 may generate a data value corresponding to the user's fingerprint. The fingerprint sensor 1610-1 may include any one of an optical or capacitive fingerprint sensor.

The input sensor 1610-2 may generate a data value corresponding to coordinate information of an input by the user's body or an input by a pen. The input sensor 1610-2 generates a data value based on a change in electrostatic capacitance according to the input. The input sensor 1610-2 may detect an input by a passive pen or transmit and receive data with an active pen.

The input sensor 1610-2 may also measure a biometric signal such as blood pressure, moisture, or body fat. For example, when the user touches a part of his or her body to a sensor layer or sensing panel and does not move for a certain period of time, the input sensor 1610-2 may detect a biometric signal based on a change in an electric field caused by the part of body and output information desired by the user to the display module 1400.

The digitizer 1610-3 may generate a data value corresponding to coordinate information input by a pen. The digitizer 1610-3 generates a data value based on an electromagnetic change caused by the input. The digitizer 1610-3 may detect an input by a passive pen or transmit and receive data with an active pen.

At least one of the fingerprint sensor 1610-1, the input sensor 1610-2, and the digitizer 1610-3 may be implemented as a sensor layer formed on the display panel DP through a continuous process. The fingerprint sensor 1610-1, the input sensor 1610-2, and the digitizer 1610-3 may be arranged above the display panel DP, and any one of the fingerprint sensor 1610-1, the input sensor 1610-2, and the digitizer 1610-3, for example, the digitizer 1610-3, may be arranged below the display panel DP.

At least two of the fingerprint sensor 1610-1, the input sensor 1610-2, and the digitizer 1610-3 may be formed to be integrated into one sensing panel through a same process. When integrated into one sensing panel, the sensing panel may be arranged between the display panel DP and a window arranged above the display panel DP. According to an embodiment, the sensing panel may be disposed on the window, but the location of the sensing panel is not particularly limited.

At least one of the fingerprint sensor 1610-1, the input sensor 1610-2, and the digitizer 1610-3 may be embedded in the display panel DP. For example, at least one of the fingerprint sensor 1610-1, the input sensor 1610-2, and the digitizer 1610-3 may be formed simultaneously through a process of forming devices (e.g., a light-emitting device, a transistor, and the like) included in the display panel DP.

In addition, the sensor module 1610 may generate an electric signal or data value corresponding to an internal or external state of the electronic device 1000. The sensor module 1610 may further include, for example, a gesture sensor, a gyro-sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illumination sensor.

The antenna module 1620 may include one or more antennas for transmitting signals or power to the outside or receiving signals or power from the outside. According to an embodiment, the communication module 1730 may transmit a signal to the external electronic device 1020 or receive a signal from the external electronic device 1020 through an antenna suitable for a communication method. An antenna pattern of the antenna module 1620 may be integrated into one component of the display device 10 (e.g., the display panel DP) or into the input sensor 1610-2.

The audio output module 1630 is a device configured to output an audio signal to the outside of the electronic device 1000, and may include, for example, a speaker used for general purposes such as multimedia reproduction or recording reproduction, and a receiver used exclusively for phone reception. According to an embodiment, the receiver may be integrated with or separated from the speaker. An audio output pattern of the audio output module 1630 may be integrated into the display device 10.

The camera module 1710 may capture a still image and a moving image. According to an embodiment, the camera module 1710 may include one or more lenses, image sensors, or image signal processors. The camera module 1710 may further include an infrared camera capable of measuring presence of the user, a location of the user, and a line of sight of the user.

The lights module 1720 may provide light. The lights module 1720 may include a light-emitting diode or a xenon lamp. The lights module 1720 may operate independently or in association with the camera module 1710.

The communication module 1730 may establish a wired or wireless communication channel between the electronic device 1000 and the external electronic device 1020, and support communication through an established communication channel. The communication module 1730 may include any one or both of a wireless communication module, such as a cellular communication module, a short-range wireless communication module, or a global navigation satellite system (GNSS) communication module, and a wired communication module, such as a local area network (LAN) communication module or a power line communication module. The communication module 1730 may communicate with the external electronic device 1020 through a short-range communication network, such as Bluetooth, Wi-Fi direct, or infrared data association (IrDA), or a long-range communication network, such as a cellular network, the Internet, or a computer network (e.g., LAN or wide area network (WAN)). Various types of the communication module 1730 described above may be implemented as one chip or as separate chips.

The input module 1300, the sensor module 1610, and the camera module 1710 may be used to control operations of the display device 10 in association with the processor 1100.

The processor 1100 outputs a command or data to the display device 10, the audio output module 1630, the camera module 1710, or the lights module 1720, based on input data received from the input module 1300. For example, the processor 1100 may generate image data in response to input data applied through a mouse or an active pen and output the image data to the display device 10, or generate command data in response to the input data and output the command data to the camera module 1710 or the lights module 1720. When input data is not received from the input module 1300 for a certain period of time, the processor 1100 may switch an operating mode of the electronic device 1000 to a low power mode or sleep mode to reduce power consumption of the electronic device 1000.

The processor 1100 outputs a command or data to the display device 10, the audio output module 1630, the camera module 1710, or the lights module 1720, based on sensing data received from the sensor module 1610. For example, the processor 1100 may compare authentication data applied by the fingerprint sensor 1610-1 with authentication data stored in the memory 1200, and execute an application according to a comparison result. The processor 1100 may execute a command based on sensing data detected by the input sensor 1610-2 or the digitizer 1610-3 or output corresponding image data to the display device 10. When the sensor module 1610 includes a temperature sensor, the processor 1100 may receive, from the sensor module 1610, temperature data about a measured temperature and perform brightness correction or the like on the image data based on the temperature data.

The processor 1100 may receive, from the camera module 1710, measurement data about the presence of the user, the location of the user, and the line of sight of the user. The processor 1100 may further perform brightness correction or the like on the image data, based on the measurement data. For example, upon determining the presence of the user through an input from the camera module 1710, the processor 1100 may output, to the display device 10, image data with brightness corrected through the data conversion circuit 1120-2 or the gamma correction circuit 1120-3.

At least some of the components may exchange a signal (e.g., a command or data) by being connected to each other through a communication method between peripheral devices (e.g., a bus, a general-purpose input and output (GPIO), a serial peripheral interface (SPI), a mobile industry processor interface (MIPI)), or an ultra-path interconnect (UPI) link. The processor 1100 may communicate with the display device 10 through a mutually agreed interface, and for example, may use any one of the above communication methods, but a communication method is not necessarily limited to the above communication methods.

The electronic device 1000, according to some embodiments of the present specification, may be any type of device. The electronic device 1000 may include, for example, at least one of a portable communication device (e.g., a smartphone), a computer device, a portable multimedia device, a portable medical device, a camera, a wearable device, or a home appliance device. The electronic device 1000 according to an embodiment is not necessarily limited to the devices described above.

Embodiments described above may be implemented independently, but it is obvious that a structure of each embodiment may be applied in combination to other embodiments.

A display device according to embodiments may have improved surface durability. The scope of the disclosure is not necessarily limited by such effects.

Various aspects are related to a layer thickness selected in a specific range. Such a selection may cause benefits as described herein; however, in various aspects such a selection may not be mandatory such that various features described herein can be understood as optional, e.g., in a case in which the benefit may not be necessarily desired or provided by alternative measures.

Example 1 is a display device including at least one folding area, the display device including: a display panel configured to display an image; and a cover window disposed on the display panel, wherein the cover window includes a base layer and a functional layer disposed on the base layer and having a thickness within a range from about 2 micrometers to about 21 micrometers, inclusive, and wherein the functional layer includes: a hard coating layer disposed on the base layer and including a hard coating material; a refractive layer disposed on the hard coating layer; and an anti-fingerprint material, wherein at least a portion of the anti-fingerprint material may float on an outermost surface of the refractive layer. Another Example 1 may include a cover window for a display panel, the cover window including: a base layer and a functional layer disposed on the base layer and having a thickness within a range from about 2 micrometers to about 21 micrometers, inclusive, wherein the functional layer includes: a hard coating layer disposed on the base layer and including a hard coating material; a refractive layer disposed on the hard coating layer; and an anti-fingerprint material, wherein at least a portion of the anti-fingerprint material may float on an outermost surface of the refractive layer. The cover window may be included in a display device having at least one folding area, wherein the cover window is disposed on a display panel configured to display an image for protecting the display panel. Another Example 1 may include a cover window for a display panel, the cover window including: a base layer and a functional layer disposed on the base layer, wherein the functional layer includes: a hard coating layer disposed on the base layer and including a hard coating material; a refractive layer disposed on the hard coating layer; and an anti-fingerprint material, wherein at least a portion of the anti-fingerprint material may be disposed at an outermost surface of the refractive layer.

In Example 2, the display device of Example 1 may optionally further include that the refractive layer includes at least one low refractive layer including a low refractive material, wherein the at least one low refractive layer includes the anti-fingerprint material and at least a portion of the anti-fingerprint material may float on an outermost surface of the at least one low refractive layer.

In Example 3, the display device of Example 2 may optionally further include that the refractive layer further includes at least one high refractive layer including a high refractive material. Another combination of Examples 2 and 3, the refractive layer includes at least one first refractive layer having a first refraction index and at least one second refractive layer having a second refraction index different from the first refraction index.

In Example 4, the display device of any one of Examples 1 to 3 may optionally further include that the anti-fingerprint material includes at least one (e.g., a single one or a combination of more than one) fluorine-based material of polytetrafluoroethylene (PTFE), fluorinated ethylene propylene (FEP), perfluoropolyether (PFPE), and fluorinated silane, or at least one silicon-based material of silica nanoparticles (SiO2), hexamethyldisiloxane (HMDSO), tetraethyl orthosilicate (TEOS), polydimethylsiloxane (PDMS), and/or phenylmethylsilicone.

In Example 5, the display device of any one of Examples 1 to 4 may optionally further include that a density of the anti-fingerprint material is higher in a portion of the refractive layer that is farther from the base layer than in a portion of the refractive layer closer to the base layer.

In Example 6, the display device of any one of Examples 1 to 5 may optionally further include that the refractive layer has a surface contact angle within a range from about 100 degrees to about 120 degrees, inclusive.

In Example 7, the display device of any one of Examples 1 to 6 may optionally further include an adhesive layer disposed between the display panel and the cover window. The adhesive layer may include a pressure sensitive adhesive (PSA) that is a semi-fluidic material.

In Example 8, the display device of any one of Examples 1 to 6 and/or of Example 7 may optionally further include that at least one of the base layer, the hard coating layer, and/or the adhesive layer further includes an ultraviolet blocking material. The ultraviolet blocking material may be configured to transmit 10 % or less ultraviolet light having a wavelength of 380 nm or less.

In Example 9, the display device of Example 8 may optionally further include that the ultraviolet blocking material is uniformly distributed within at least one of the base layer, the hard coating layer, and the adhesive layer.

In Example 10, the display device of any one of Examples 1 to 9 may optionally further include that the hard coating material includes at least one (e.g., a single one or a combination of more than one) material of siloxane resin, epoxy resin, and acryl-based resin. A thickness of the hard coating layer may be in a range from about 1 micrometer to about 20 micrometers, inclusive.

In Example 11, the display device of any one of Examples 1 to 10 as long as referring to Example 2 may optionally further include that the low refractive material includes at least one (e.g., a single one or a combination of more than one) material of an amino-based low refractive material, a silane-based low refractive material, and/or an acrylate-based low refractive material. A thickness of the at least one low refractive layer may be in a range from about 10 nanometers to about 250 nanometers, inclusive.

In Example 12, the display device of any one of Examples 1 to 11 as long as referring to Example 3 may optionally further include that the high refractive material includes at least one (e.g., a single one or a combination of more than one) high refractive inorganic material of titanium dioxide, zirconium oxide, silicon carbide, zinc sulfide, and titanium carbide, or includes at least one (e.g., a single one or a combination of both) high refractive organic material from among polyimide and polythiophene. A thickness of the at least one high refractive layer may be in a range from about 10 nanometers to about 250 nanometers, inclusive.

In Example 13, the display device of any one of Examples 1 to 12 may optionally further include that the display panel includes: a substrate divided into a display area and a peripheral area; an organic light-emitting diode disposed in the display area of the substrate; and, optionally, an encapsulation layer sealing the organic light-emitting diode. The display device may further include, between the display panel and the cover window: a touch layer disposed on the encapsulation layer; and a color filter layer disposed on the touch layer.

Example 14 is a display device including at least one folding area, the display device including: a display panel configured to display an image; and a cover window disposed on the display panel, wherein the cover window includes a base layer and a functional layer, wherein the functional layer includes: a hard coating layer disposed on the base layer and including a hard coating material; a primer layer disposed on the hard coating layer and including a primer material; and an anti-fingerprint layer disposed on the primer layer and including an anti-fingerprint material. A thickness of the primer layer may be in a range from about 5 nanometers to about 30 nanometers, inclusive. The primer material may include at least one (e.g., a single one or a combination of more than one) material of a silane-based material, an acrylate-based material, and/or an epoxy-based material.

In Example 15, the display device of Example 14 may optionally further include: between the hard coating layer and the primer layer, a low refractive layer including a low refractive material. The low refractive material may have a thickness in a range from about 10 nanometers to about 250 nanometers, inclusive.

In Example 16, the display device of Example 15 may optionally further include: between the hard coating layer and the low refractive layer, a high refractive layer including a high refractive material. The high refractive layer may have a thickness in a range from about 10 nanometers to about 250 nanometers, inclusive.

In Example 17, the display device of any one of Examples 14 to 16 may optionally further include that a thickness of the anti-fingerprint layer is in a range from about 5 nanometers to about 30 nanometers, inclusive. The anti-fingerprint material may include at least one material of a fluorine-based material and/or a silicon-based material.

Example 18 is an electronic device including: a controller configured to generate a scan input signal; a power module configured to generate a scan input voltage; a display panel including a substrate divided into a display area in which a pixel circuit is arranged and a peripheral area surrounding the display area, a scan driver arranged in the peripheral area, the scan driver configured to receive the scan input signal and the scan input voltage, and output a scan signal to the pixel circuit, and an encapsulation layer sealing at least the display area; a touch layer disposed on the encapsulation layer; a color filter layer disposed on the touch layer; and a cover window disposed on the color filter layer. The cover window may be configured as described for the cover window in accordance with any one of Examples 1 to 17. The cover window may include: a base layer; and a functional layer disposed on the base layer, the functional layer having a thickness in a range from about 2 micrometers to about 21 micrometers, inclusive, and having an anti-fingerprint material disposed thereon and/or therein, wherein at least a portion of the anti-fingerprint material may float on an outermost surface of the functional layer, wherein the anti-fingerprint material includes at least one material of a fluorine-based material and a silicon-based material.

In Example 19, the electronic device of Example 18 may optionally further include that the functional layer includes a hard coating layer disposed on the base layer, including a hard coating material. The hard coating layer may have a thickness in a range from about 1 micrometer to about 20 micrometers, inclusive. The hard coating layer may have the anti-fingerprint material disposed thereon and/or therein and at least a portion of the anti-fingerprint material may float on an outermost surface of the hard coating layer.

In Example 20, the electronic device of Example 18 may optionally further include that the functional layer includes: a hard coating layer disposed on the base layer, including a hard coating material. The hard coating layer may have a thickness in a range from about 1 micrometer to about 20 micrometers, inclusive. At least one low refractive layer may be disposed on the hard coating layer. The at least one low refractive layer may have a thickness that is less than that of the hard coating layer, and including at least one low refractive material. The at least one low refractive layer may have the anti-fingerprint material disposed therein and at least a portion of the anti-fingerprint material may float on an outermost surface of the at least one low refractive layer.

Various aspects are related to forming a single layer (e.g., a refractive layer, e.g., a hard coating layer) having anti-fingerprint material (e.g., anti-fingerprint particles) included therein while having an additional function, such as a refractive function due to included refraction material and/or a protection function due to included hard coating material as described herein. In some aspects, the single layer is formed by a single coating process, e.g., spin-coating only as an example. In some aspects, the single layer may be free of (lateral) interlayer interfaces, e.g., forming a continuous (coherent) single layer and not composed of different layers adhered to one another. In some aspects, the single layer is made of a same matrix material into which the anti-fingerprint material (e.g., anti-fingerprint particles) are embedded.

Various aspects are related to forming a single layer having anti-fingerprint material (e.g., anti-fingerprint particles) included therein, wherein during layer formation, the anti-fingerprint material floats towards a (e.g., exposed, e.g., uppermost, e.g., outermost) surface (S) of the single layer. Therefore, after layer formation, the anti-fingerprint material is disposed at the surface (S) of the single layer, e.g., in a surface region of the single layer.

The disclosure has been described with reference to the embodiments shown in the drawings, but the embodiments may be examples and it should be understood by one of ordinary skill in the art that various modifications and equivalent embodiments are possible.

## Claims

1. A display device (10) comprising at least one folding area (FA), the display device (10) comprising:
a display panel (DP) configured to display an image; and
a cover window (CW, 910) disposed on the display panel,
wherein the cover window (CW, 910) comprises a base layer (921) and a functional layer (922, 924) disposed on the base layer (921), the functional layer (922, 924) having a thickness within a range from about 2 micrometers to about 21 micrometers, inclusive, and
wherein the functional layer (922, 924) comprises:
a hard coating layer (922) disposed on the base layer (921) and comprising a hard coating material;
a refractive layer (924) disposed on the hard coating layer (922); and
an anti-fingerprint material (924a),
wherein at least a portion of the anti-fingerprint material (924a) is disposed at an outermost surface of the refractive layer (924).

2. The display device (10) of claim 1, wherein the refractive layer (924) comprises at least one low refractive layer (924) comprising a low refractive material,
wherein the at least one low refractive layer (924) comprises the anti-fingerprint material (924a) and at least a portion of the anti-fingerprint material is disposed at an outermost surface (S) of the at least one low refractive layer (924).

3. The display device (10) of claim 1, wherein the refractive layer (924) comprises at least one high refractive layer (923) comprising a high refractive material, and at least one low refractive layer (924) disposed on the at least one high refractive layer (923) and comprising a low refractive material,
wherein the at least one low refractive layer has the anti-fingerprint material disposed thereon and at least a portion of the anti-fingerprint material is disposed at an outermost surface of the at least one low refractive layer.

4. The display device (10) of any one of claims 1 to 3, wherein the anti-fingerprint material (924a) comprises at least one fluorine-based material of polytetrafluoroethylene, PTFE, fluorinated ethylene propylene, FEP, perfluoropolyether, PFPE, and/or fluorinated silane, or at least one silicon-based material of silica nanoparticles, SiO₂, hexamethyldisiloxane, HMDSO, tetraethyl orthosilicate, TEOS, polydimethylsiloxane, PDMS, and/or phenylmethylsilicone.

5. The display device (10) of any one of claims 1 to 4, wherein a density of the anti-fingerprint material (924a) is higher in a first portion of the refractive layer (924) that is farther from the base layer (921) than in a second portion of the refractive layer (924) closer to the base layer (921); and/or
wherein a density of the anti-fingerprint material (924a) is higher in a first portion of the refractive layer (924) that is closer to an exposed surface (S) of the refractive layer (924) than in a second portion of the refractive layer (924) farther from the exposed surface (S) of the refractive layer (924).

6. The display device (10) of any one of claims 1 to 5, wherein the refractive layer (924) has a surface contact angle within a range from about 100 degrees to about 120 degrees, inclusive.

7. The display device (10) of any one of claims 1 to 6, further comprising an adhesive layer disposed between the display panel (DP) and the cover window (CW, 910),
wherein the adhesive layer comprises a pressure sensitive adhesive, PSA, that is a semi-fluidic material.

8. The display device (10) of claim 7, wherein at least one of the base layer (921), the hard coating layer (922) and the adhesive layer further comprises an ultraviolet blocking material (922a), and
wherein the ultraviolet blocking material is configured to transmit 10 % or less ultraviolet light having a wavelength of 380 nm or less.

9. The display device (10) of claim 8, wherein the ultraviolet blocking material is uniformly distributed within at least one of the base layer (921), the hard coating layer (922), and the adhesive layer.

10. The display device (10) of any one of claims 1 to 9, wherein the hard coating material comprises at least one material of siloxane resin, epoxy resin, and/or acryl-based resin, and wherein a thickness of the hard coating layer (922) is in a range from about 1 micrometer to about 20 micrometers, inclusive.

11. The display device (10) of claim 2 or 3, wherein the low refractive material (924) comprises at least one material of an amino-based low refractive material, a silane-based low refractive material, and/or an acrylate-based low refractive material, and
wherein a thickness of the at least one low refractive layer is in a range from about 10 nanometers to about 250 nanometers, inclusive.

12. The display device (10) of claim 3, wherein the high refractive material comprises at least one high refractive inorganic material of titanium dioxide, zirconium oxide, silicon carbide, zinc sulfide, and/or titanium carbide, or comprises at least one high refractive organic material from among polyimide and/or polythiophene, and
wherein a thickness of the at least one high refractive layer (923) is in a range from about 10 nanometers to about 250 nanometers, inclusive.

13. The display device (10) of any one of claims 1 to 12, wherein the display panel (DP) comprises:
a substrate divided into a display area (DA) and a peripheral area (PA);
an organic light-emitting diode disposed in the display area (DA) of the substrate; and
an encapsulation layer (400) sealing the organic light-emitting diode,
wherein the display device (10) further comprises, between the display panel and the cover window (CW, 910):
a touch layer (700) disposed on the encapsulation layer (400); and
a color filter layer (800) disposed on the touch layer.

14. A display device (10) comprising at least one folding area (FA), the display device (10) comprising:
a display panel (DP) configured to display an image; and
a cover window (CW, 910) disposed on the display panel,
wherein the cover window (CW, 910) comprises a base layer (921) and a functional layer,
wherein the functional layer comprises:
a hard coating layer (922) disposed on the base layer (921) and comprising a hard coating material;
a primer layer (925) disposed on the hard coating layer (922) and comprising a primer material; and
an anti-fingerprint layer (926) disposed on the primer layer (925) and comprising an anti-fingerprint material,
wherein a thickness of the primer layer (925) is in a range from about 5 nanometers to about 30 nanometers, inclusive, and
wherein the primer material comprises at least one material of a silane-based material, an acrylate-based material, and an epoxy-based material.

15. An electronic device (1000) with improved surface durability, comprising:
a controller (1100) configured to generate a scan input signal;
a power module (1500) configured to generate a scan input voltage;
a display panel (DP) comprises a substrate divided into a display area in which a pixel circuit is arranged and a peripheral area (PA) surrounding the display area (DA), a scan driver arranged in the peripheral area (PA), the scan driver configured to receive the scan input signal and the scan input voltage, and output a scan signal to the pixel circuit, and an encapsulation layer (400) sealing at least the display area (DA);
a touch layer (700) disposed on the encapsulation layer (400);
a color filter layer (800) disposed on the touch layer; and
a cover window (CW, 910) disposed on the color filter layer,
wherein the cover window comprises:
a base film (921); and
a functional layer (922) disposed on the base film, having a thickness in a range of about 2 micrometers to about 21 micrometers, inclusive, and having an anti-fingerprint material disposed thereon, wherein at least a portion of the anti-fingerprint material is disposed at an outermost surface of the functional layer,
wherein the anti-fingerprint material comprises at least one material of a fluorine-based material and a silicon-based material.
